(19) Europäisches Patentamt / European Patent Office / Office européen des brevets

(11) **EP 4 435 834 A1**

(12) **EUROPEAN PATENT APPLICATION**

(43) Date of publication:
**25.09.2024 Bulletin 2024/39**

(21) Application number: **24160062.6**

(22) Date of filing: **27.02.2024**

(51) International Patent Classification (IPC):
***H01L 21/311*** *(2006.01)* ***H01L 21/67*** *(2006.01)*
***H01L 21/66*** *(2006.01)*

(52) Cooperative Patent Classification (CPC):
**H01L 21/31116; H01L 21/67248;** H01L 22/26

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.02.2023 JP 2023030028**

(71) Applicant: **Kioxia Corporation**
**Tokyo 105-0023 (JP)**

(72) Inventors:
- **Moriyama, Makoto**
  **Tokyo, 108-0023 (JP)**
- **Imamura, Tsubasa**
  **Tokyo, 108-0023 (JP)**
- **Hashimoto, Takaki**
  **Tokyo, 108-0023 (JP)**
- **Furubayashi, Ai**
  **Tokyo, 108-0023 (JP)**

(74) Representative: **Marks & Clerk LLP**
**15 Fetter Lane**
**London EC4A 1BW (GB)**

# (54) METHOD FOR MANUFACTURING SEMICONDUCTOR DEVICE, FILM THICKNESS MEASUREMENT METHOD, TEMPERATURE MEASUREMENT METHOD, AND TEMPERATURE MEASUREMENT SUBSTRATE

(57) According to one embodiment, a method for manufacturing a semiconductor device includes: preparing a substrate (200), the substrate (200) including: a plurality of light shielding layers (210) arranged at predetermined intervals to shield light having a predetermined wavelength; a workpiece film (110) located on the plurality of light shielding layers (210), and including a plurality of first insulating layers (NL) and a plurality of second insulating layers (OL) alternately stacked one by one; and a mask pattern (120p) located on the workpiece film (110) and having a plurality of openings; and etching the workpiece film (110) exposed from the plurality of openings, wherein the etching of the workpiece film (110) includes: irradiating a back surface of the substrate (200) with the light while etching the workpiece film (110); observing interference light (239sb) generated by interference between first reflected light (238s) reflected by the back surface of the substrate (200) and second reflected light (238b) transmitted through the substrate (200) and reflected by bottom surfaces of the plurality of light shielding layers (238b); calculating a temperature of the substrate (200) during etching processing based on the interference light (239sb); and adjusting the temperature of the substrate (200) during the etching processing based on the temperature of the substrate (200) calculated from the interference light (239sb).

FIG.1

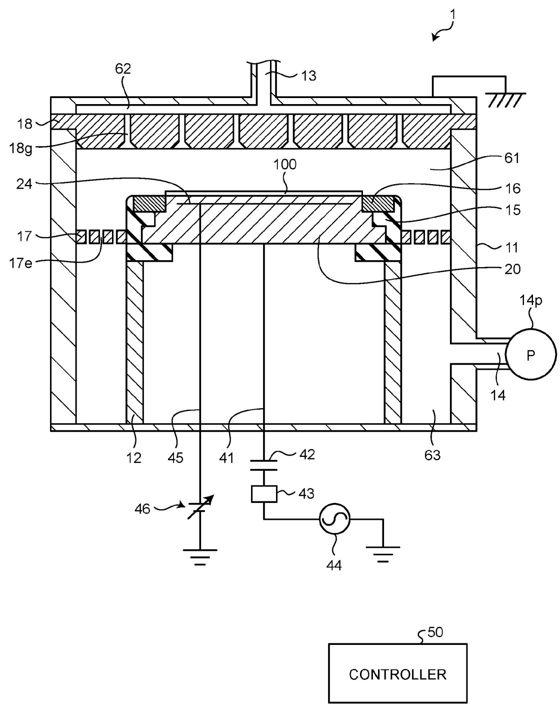




Processed by Luminess, 75001 PARIS (FR)

## Description

CROSS-REFERENCE TO RELATED APPLICATIONS

This application is based upon and claims the benefit of priority from Japanese Patent Application No. 2023-030028, filed on February 28, 2023; the entire contents of which are incorporated herein by reference.

FIELD

Embodiments described herein relate generally to a method for manufacturing a semiconductor device, a film thickness measurement method, a temperature measurement method, and a temperature measurement substrate.

BACKGROUND

In the manufacturing process of the semiconductor device, etching processing may be performed on a workpiece film of a substrate by plasma. In the etching processing using plasma, it is preferable to obtain a desired processed shape by controlling various etching conditions with high accuracy. Therefore, the problem is how to accurately acquire various types of information such as a film thickness of a workpiece film on the substrate and a substrate temperature during etching processing.

BRIEF DESCRIPTION OF THE DRAWINGS

Fig. 1 is a cross-sectional view schematically illustrating an example of a configuration of a plasma processing apparatus according to a first embodiment;
Fig. 2 is a schematic diagram illustrating an example of a configuration of an interferometer according to the first embodiment;
Figs. 3A and 3B are cross-sectional views sequentially exemplifying some procedures for a method for manufacturing a semiconductor device according to the first embodiment;
Figs. 4A and 4B are cross-sectional views sequentially exemplifying some procedures for a method for manufacturing a semiconductor device according to the first embodiment;
Figs. 5A to 5E are diagrams for explaining data obtained by the interferometer according to the first embodiment;
Fig. 6 is a cross-sectional view illustrating an example of a configuration of a semiconductor device according to the first embodiment;
Fig. 7 is a flowchart illustrating an example of procedures for plasma processing on a wafer according to the first embodiment;
Fig. 8 is a cross-sectional view schematically illustrating an example of a configuration of a plasma processing apparatus according to a second embodiment;
Figs. 9A and 9B are schematic views illustrating an example of a temperature adjustment mechanism of an electrostatic chuck included in the plasma processing apparatus according to the second embodiment;
Figs. 10A to 10C are cross-sectional views sequentially exemplifying some procedures for a method for manufacturing a semiconductor device according to the second embodiment;
Figs. 11A and 11B are cross-sectional views sequentially exemplifying some procedures for a method for manufacturing a semiconductor device according to the second embodiment;
Figs. 12A and 12B are cross-sectional views sequentially exemplifying some procedures for a method for manufacturing a semiconductor device according to the second embodiment;
Fig. 13 is a schematic diagram illustrating a light shielding layer and components positioned on and under the light shielding layer according to the second embodiment;
Figs. 14A and 14B are schematic diagrams each illustrating a state of a wafer during plasma processing according to the second embodiment;
Fig. 15 is a flowchart illustrating an example of procedures for plasma processing on the wafer according to the second embodiment;
Figs. 16A and 16B are graphs illustrating optical characteristics of materials that can be candidates for light shielding layer according to a modification of the second embodiment; and
Fig. 17 is a graph illustrating a transmittance of a light shielding layer according to a modification of the second embodiment.

DETAILED DESCRIPTION

In general, according to one embodiment, a method for manufacturing a semiconductor device includes: preparing a substrate, the substrate including: a plurality of light shielding layers arranged at predetermined intervals to shield light having a predetermined wavelength; a workpiece film located on the plurality of light shielding layers, and including a plurality of first insulating layers and a plurality of second insulating layers alternately stacked one by one; and a mask pattern located on the workpiece film and having a plurality of openings; and etching the workpiece film exposed from the plurality of openings, wherein the etching of the workpiece film includes: irradiating a back surface of the substrate with the light while etching the workpiece film; observing interference light generated by interference between first reflected light reflected by the back surface of the substrate and second reflected light transmitted through the substrate and reflected by bottom surfaces of the plurality of light shielding layers; calculating a temperature of the substrate during etching processing based on the interference light; and adjusting the temperature of the substrate during the etching processing based on the temperature of the substrate calculated from the interference light.

Hereinafter, embodiments of the present invention will be described in detail with reference to the drawings. Note that the present invention is not limited by the following embodiments. In addition, constituent elements in the following embodiments include those that can be easily assumed by those skilled in the art or those that are substantially identical thereto.

[First Embodiment]

Hereinafter, a first embodiment will be described in detail with reference to the drawings.

(Example of Configuration of Plasma Processing Apparatus)

Fig. 1 is a cross-sectional view schematically illustrating an example of a configuration of a plasma processing apparatus 1 according to the first embodiment. The plasma processing apparatus 1 is configured as, for example, a plasma etching apparatus that performs etching processing on a workpiece film formed on a wafer 100 by plasma.

As illustrated in Fig. 1, the plasma processing apparatus 1 includes a chamber 11 that is a processing container for processing the wafer 100. The chamber 11 is made of, for example, aluminum, and can be hermetically sealed.

A gas supply port 13 is provided in an upper portion of the chamber 11. A gas supply device, which is not illustrated, is connected to the gas supply port 13 through a pipe to supply a processing gas to be used at the time of processing the wafer 100.

A shower head 18 functioning as an upper electrode is provided below the gas supply port 13. The shower head 18 has a plurality of gas discharge ports 18g penetrating through the shower head 18 in a plate thickness direction. The processing gas supplied from the gas supply port 13 is introduced into the chamber 11 through the gas discharge ports 18g. An electrostatic chuck 20 is disposed below the shower head 18 so as to face the shower head 18.

The electrostatic chuck 20 is configured to not only electrostatically attract and support the wafer 100 to be processed in the chamber 11 but also be able to adjust the temperature of the wafer 100, and also functions as a lower electrode. A port (not illustrated) for loading/unloading the wafer 100 is provided in a side surface of the chamber 11, and the wafer 100 is placed on the electrostatic chuck 20 in the chamber 11 by a conveyance arm, which is not illustrated, from the loading/unloading port.

The electrostatic chuck 20 is supported on a support 12 protruding in a tubular shape vertically upward from a bottom wall near the center of the chamber 11. The support 12 supports the electrostatic chuck 20 near the center of the chamber 11 separated from the shower head 18 by a predetermined distance so as to face the shower head 18 in parallel. With such a structure, the shower head 18 and the electrostatic chuck 20 constitute a pair of parallel plate electrodes.

The electrostatic chuck 20 includes a chuck mechanism that electrostatically attracts the wafer 100. The chuck mechanism includes a chuck electrode 24 serving as a power supply plate, a power supply line 45, and a power supply 46. The power supply 46 is connected to the chuck electrode 24 via the power supply line 45. With such a mechanism, DC power is supplied from the power supply 46 to the chuck electrode 24, and an upper surface of the electrostatic chuck 20 is electrostatically charged.

The power supply line 41 is connected to the electrostatic chuck 20. A blocking capacitor 42, a matching device 43, and a radio frequency power supply 44 are connected to the power supply line 41. During plasma processing, radio frequency power having a predetermined frequency is supplied from the radio frequency power supply 44 to the electrostatic chuck 20. With such a mechanism, the electrostatic chuck 20 also functions as a lower electrode.

An insulator ring 15 is disposed on an outer periphery of the electrostatic chuck 20 so as to cover the side surface and a peripheral edge portion of the bottom surface of the electrostatic chuck 20. An outer peripheral ring 16 is provided on the insulator ring 15 so as to surround the outer periphery of the electrostatic chuck 20. The outer peripheral ring 16 adjusts an electric field so that the electric field is not deflected at a peripheral edge portion of the wafer 100 in a vertical direction, that is, in a direction perpendicular to the surface of the wafer 100, during the plasma processing on the wafer 100.

A baffle plate 17 is provided between the insulator ring 15 and the side wall of the chamber 11. The baffle plate 17 has a plurality of gas discharge holes 17e penetrating through the baffle plate 17 in the plate thickness direction.

A gas exhaust port 14 is provided below the baffle plate 17 in the chamber 11. A vacuum pump 14p that exhausts the atmosphere in the chamber 11 is connected to the gas exhaust port 14.

A region in the chamber 11 partitioned by the electrostatic chuck 20 and the baffle plate 17 and the shower head 18 is a plasma processing chamber 61. An upper region in the chamber 11 partitioned by the shower head 18 is a gas supply chamber 62. A lower region in the chamber 11 partitioned by the electrostatic chuck 20 and the baffle plate 17 is a gas exhaust chamber 63.

The plasma processing apparatus 1 includes a controller 50 that controls each part of the plasma processing apparatus 1 such as the power supply 46, the matching device 43, the radio frequency power supply 44, and the gas supply device. The controller 50 is configured as a computer including a central processor (CPU), a read only memory (ROM), a random access memory (RAM), and the like, which are not illustrated. The controller 50 may be configured as an application specific integrated circuit (ASIC) or the like having a function for use in the plasma processing apparatus 1.

At the time of plasma processing on the wafer 100, the wafer 100 to be processed is placed on the electrostatic chuck 20 and attracted by the chuck mechanism under the control of the controller 50. The inside of the chamber 11 is evacuated by the vacuum pump 14p connected to the gas exhaust port 14. When the inside of the chamber 11 reaches a predetermined pressure, a processing gas is supplied from the gas supply device, which is not illustrated, to the gas supply chamber 62, and is supplied to the plasma processing chamber 61 via the gas discharge ports 18g of the shower head 18.

In addition, by applying a radio frequency voltage to the electrostatic chuck 20 as a lower electrode in a state where the shower head 18 as an upper electrode is grounded under the control of the controller 50, plasma is generated in the plasma processing chamber 61. On the lower electrode side, a potential gradient is generated between the plasma and the wafer 100 due to self-bias by the radio frequency voltage, ions in the plasma are accelerated to the electrostatic chuck 20, and anisotropic etching processing is performed.

(Example of Configuration of Interferometer)

In the plasma processing apparatus 1 according to the first embodiment described above, processing is performed, for example, by etching workpiece films having various materials and film thicknesses into a desired shape. The workpiece film is formed of a predetermined material with a predetermined film thickness as a target. However, the film thickness of the workpiece film may vary for each wafer 100.

Therefore, in the configuration according to the first embodiment, a film thickness of a workpiece film is measured in advance for each wafer 100 using an interferometer 3, which will be described below, and etching is performed after an etching condition such as a processing time is optimized based on a result of measuring the film thickness.

Fig. 2 is a schematic diagram illustrating an example of a configuration of the interferometer 3 according to the first embodiment. The interferometer 3 according to the first embodiment can measure a film thickness of a workpiece film formed on a wafer 100 to be measured based on interference of light.

As illustrated in Fig. 2, the interferometer 3 includes a light source 31, an optical coupler 32, a collimator lens 33, a placing table 34, a sensor head 35, a spectroscope 36, an optical fiber cable 37, and an arithmetic device 30.

The optical fiber cable 37 connects the light source 31, the optical coupler 32, the collimator lens 33, the sensor head 35, and the spectroscope 36 to each other.

The light source 31 is a laser diode (LD) or the like that emits low-coherent laser light. The coherence is an index indicating a degree of coherence between optical waves, and the low-coherent light is light having a small coherence length, that is, a small optical path length difference that causes interference fringes. By performing a measurement using such light, it is possible to observe the measurement target object with a resolution corresponding to the coherence length of the light.

With such a light source 31, the interferometer 3 according to the first embodiment is configured as a low coherence interferometer (LCI).

Note that the light emitted from the light source 31 is infrared light, and for example, light having a wavelength of 1200 nm or more, more preferably 1250 nm or more and 1350 nm or less, can be used.

The optical coupler 32 is a passive optical device that demultiplexes and multiplexes the light from the light source 31. The optical coupler 32 emits the light from the light source 31 to the collimator lens 33.

The collimator lens 33 is an aberration-corrected lens so that parallel light can be obtained. The collimator lens 33 concentrates the light from the optical coupler 32 at one point and emits the concentrated light.

The sensor head 35 is provided at the tip of the optical fiber cable 37, and is inserted into a through hole provided in the placing table 34 on which the wafer 100 can be placed. Thus, the back surface of the wafer 100 placed on the placing table 34 is irradiated with the light passing through the light source 31, the optical coupler 32, and the collimator lens 33.

The light emitted to the back surface of the wafer 100 is reflected by the wafer 100 itself, a workpiece film provided on the wafer 100, or the like. A plurality of light beams reflected by respective parts of the wafer 100 interfere with each other, are detected by the sensor head 35 as a plurality of types of interference light, and are emitted to the spectroscope 36 via the collimator lens 33 and the optical coupler 32.

The spectroscope 36 measures an interference spectrum obtained by performing spectroscopic analysis on the interference light detected by the sensor head 35 for each wavelength. The interference spectrum obtained by the spectroscope 36 indicates an intensity of the interference light for each wavelength. That is, the interference spectrum is expressed as a graph in which the horizontal axis represents a wavelength of light and the vertical axis represents an intensity of light. The spectroscope 36 outputs the measured interference spectrum to the arithmetic device 30.

The arithmetic device 30 is configured as a computer including a CPU, a ROM, a RAM, and the like, which are not illustrated, and executes various calculations based on an interference spectrum. The arithmetic device 30 obtains a correlation signal by, for example, inverse fast Fourier transform (iFFT), and calculates a thickness or the like of each part of the wafer 100 from an optical path length of each part of the wafer 100 indicated by a peak of the correlation signal.

(Method for Manufacturing Semiconductor Device)

Next, an example of a method for manufacturing a semiconductor device according to the first embodiment will be described with reference to Figs. 3A to 6. The method for manufacturing the semiconductor device according to the first embodiment includes measuring a film thickness of a workpiece film using the interferometer 3 described above and etching processing of the workpiece film using the plasma processing apparatus 1 described above.

Figs. 3A and 4B are cross-sectional views sequentially exemplifying some procedures for the method for manufacturing the semiconductor device according to the first embodiment. Figs. 3A and 4B mainly illustrate how a film thickness a workpiece film 110 is measured by the interferometer 3 and how the workpiece film 110 is etched by the plasma processing apparatus 1.

As illustrated in Fig. 3A, a workpiece film 110 and a CVD-carbon layer 120 are formed in this order on a wafer 100 such as a silicon wafer. A single layer or stacked films may be provided between the wafer 100 and the workpiece film 110.

The workpiece film 110 is, for example, a film in which a plurality of different kinds of layers are stacked in multiple layers. As an example, the workpiece film 110 is a film in which silicon nitride (SiN) layers NL as first insulating layers and silicon oxide (SiO) layers OL as second insulating layers are alternately stacked one by one. Each of the number of silicon nitride layers NL and the number of silicon oxide layers OL included in the workpiece film 110 may be about 50 to 400.

The CVD-carbon layer 120 is an organic layer mainly made of carbon and formed by, for example, plasma chemical vapor deposition (CVD) or the like. An example of such a CVD-carbon layer 120 is an advanced patterning film (APF) manufactured by Applied Materials, Inc.

In addition, a film thickness of the workpiece film 110 is measured using the interferometer 3 described above. That is, the wafer 100 on which the workpiece film 110 and the CVD-carbon layer 120 are formed is placed on the placing table 34, and the back surface of the wafer 100 is irradiated with laser light or the like from the light source 31 via the sensor head 35.

A part of the laser light with which the back surface of the wafer 100 is irradiated is reflected by the back surface of the wafer 100 and detected as reflected light 38s by the sensor head 35 of the interferometer 3. Another part of the laser light is transmitted through the wafer 100, is reflected by a bottom surface, also referred to as a lower surface, of the workpiece film 110, that is, a surface in contact with the front surface of the wafer 100, and is detected as reflected light 38p by the sensor head 35. Still another part of the laser light is transmitted through the wafer 100 and the workpiece film 110, is reflected by a bottom surface, also referred to as a lower surface of the CVD-carbon layer 120, that is, a surface in contact with an upper surface of the workpiece film 110, and is detected as reflected light 38c by the sensor head 35.

The spectroscope 36 of the interferometer 3 measures a spectrum of an interference wave obtained by interference between the reflected light 38s, the reflected light 38p, and the reflected light 38c. The arithmetic device 30 of the interferometer 3 calculates a film thickness of the workpiece film 110 by performing various calculations based on the interference spectrum measured by the spectroscope 36.

That is, an optical path length of the wafer 100 is obtained from interference light 39sp between the reflected light 38s from the back surface of the wafer 100 and the reflected light 38p from the lower surface of the workpiece film 110. The optical path length is a distance by which light travels in a vacuum within a time that is the same as the time during which light travels in a predetermined substance, and is expressed as a product of a refractive index of the target substance and the distance. Therefore, since the optical path length of the wafer 100 depends on the refractive index and the thickness of the wafer 100, the thickness of the wafer 100 can be obtained from the optical path length of the wafer 100 made of a known material.

Further, a total optical path length of the wafer 100 and the workpiece film 110 is obtained from interference light 39sc between the reflected light 38s from the back surface of the wafer 100 and the reflected light 38c from the lower surface of the CVD-carbon layer 120. If the influence of the optical path length of the wafer 100 described above is subtracted from the total optical path length, the optical path length of the workpiece film 110 alone can be obtained, and the film thickness of the workpiece film 110 can be obtained from the optical path length of the workpiece film 110 made of a known material.

Note that the measurement of the film thickness is preferably performed at a plurality of points within a plane of the wafer 100. When a plurality of pieces of measurement data are obtained from one wafer 100, an average value or the like of these pieces of measurement data can be used as a film thickness of the workpiece film 110.

As illustrated in Fig. 3B, a silicon oxynitride (SiON) layer 130 and a resist pattern 140p are further formed in this order on the CVD-carbon layer 120. The silicon oxynitride layer 130 is formed by, for example, plasma CVD or the like. The resist pattern 140p is formed by spin-coating, exposing, and developing a resist layer, and has a pattern corresponding to the shape desired to be formed on the workpiece film 110 by plasma processing, which will be described below. In the example of Fig. 3B, in order to form through holes in the workpiece film 110, the resist pattern 140p has a pattern including a plurality of hole-shaped openings.

Thereafter, the silicon oxynitride layer 130 is etched using the resist pattern 140p as a mask, and the pattern of the resist pattern 140p is transferred to the silicon oxynitride layer 130. Further, the CVD-carbon layer 120 is etched using the silicon oxynitride layer 130 to which the pattern is transferred as a mask, and the pattern of the silicon oxynitride layer 130 is further transferred to the CVD-carbon layer 120.

As illustrated in Fig. 4A, a mask pattern 120p is formed on the workpiece film 110 by transferring the pattern to the CVD-carbon layer 120 through the etching processing. Note that the resist pattern 140p and the silicon oxynitride layer 130 sequentially disappear by the etching processing.

As illustrated in Fig. 4B, the workpiece film 110 exposed from the openings of the mask pattern 120p is etched and penetrated by, for example, the above-described plasma processing apparatus 1. As a result, a plurality of through holes 111 are formed in the workpiece film 110. The front surface of the wafer 100 is exposed from bottom surfaces of the through holes 111.

Note that the etching of the silicon oxynitride layer 130 and the etching of the CVD-carbon layer 120 may also be performed by the plasma processing apparatus 1. In this case, the silicon oxynitride layer 130, the CVD-carbon layer 120, and the workpiece film 110 may be consecutively etched in a lump.

When the through holes 111 are formed by etching the workpiece film 110 described above, a film thickness measurement result of the interferometer 3 is used. That is, when etching is performed on the workpiece film 110, an etching condition under which the etching time or the like is adjusted is used, based on the film thickness of the workpiece film 110 obtained by the interferometer 3, so that the workpiece film 110 is more reliably penetrated and the exposed front surface of the wafer 100 is not unnecessarily etched away.

Here, more detailed examples of data obtained by the interferometer 3 are illustrated in Figs. 5A to 5E.

Figs. 5A to 5E are diagrams for explaining data obtained by the interferometer 3 according to the first embodiment. Fig. 5A is an example of spectrum data on an optical path length of the wafer 100 obtained by the interferometer 3. Each of Figs. 5B to 5E illustrates a state of the wafer 100 when the spectrum data of Fig. 5A is acquired.

More specifically, Fig. 5B is a cross-sectional view of a wafer 100 alone. Fig. 5C is a cross-sectional view of the wafer 100 after the workpiece film 110 and the CVD-carbon layer 120 are formed. Fig. 5D is a cross-sectional view of the wafer 100 after a pattern is transferred to the CVD-carbon layer 120 and a mask pattern 120p is formed. Fig. 5E is a cross-sectional view of the wafer 100 after the etching on the workpiece film 110 is completed and through holes 111 are formed.

That is, the spectrum data obtained from the wafer 100 of Fig. 5C corresponds to data used for measuring a film thickness of the workpiece film 110 in the process of manufacturing the semiconductor device according to the first embodiment described above. On the other hand, the spectrum data obtained from the wafer 100 of Figs. 5B, 5D, and 5E is illustrated in Fig. 5A for reference.

As illustrated in Fig. 5A, the interferometer 3 obtains, from the wafer 100 in each state, spectrum data in which the horizontal axis represents an optical path length and the vertical axis represents an intensity. The spectrum obtained by the interferometer 3 greatly varies depending on the state of the wafer 100.

For example, in a state of the wafer 100 alone when a lot of wafers 100 are input, spectrum data having one peak in a predetermined optical path length is obtained. The peak of the optical path length is obtained from interference light between the reflected light from the back surface of the wafer 100 and the reflected light reflected without being transmitted through the front surface of the wafer 100.

In the wafer 100 alone, a workpiece film 110 and the like are not formed on the wafer 100, and the front surface of the wafer 100 is in contact with the atmosphere at the time of measurement by the interferometer 3, such as air. Since reflection and transmission of light occur on a plane of contact between substances having different refractive indexes, interference light is observed due to reflected light reflected by the front and back surfaces of the wafer 100 even in the case where the wafer 100 is alone as described above. As described above, the peak of the spectrum data of the wafer 100 alone indicates an optical path length of the wafer 100.

In addition, spectrum data having two peaks is obtained from the wafer 100 on which the workpiece film 110 and the CVD-carbon layer 120 have been formed.

One of the two peaks is a peak indicating an optical path length of the wafer 100 obtained from the interference light 39sp between the reflected light 38s from the back surface of the wafer 100 and the reflected light 38p from the lower surface of the workpiece film 110 illustrated in Fig. 3A.

It is considered that the reason why the intensity of the peak indicating the optical path length of the wafer 100 is lower than the intensity of the peak obtained from the wafer 100 alone that the workpiece film 110 formed on the wafer 100 weakens reflection of light on the front surface of the wafer 100. That is, it is estimated that the reflected light 38s from the front surface of the wafer 100 is attenuated, because a part of the light is transmitted from the wafer 100 to the workpiece film 110.

The other one of the two peaks included in the spectrum data is a peak indicating a total optical path length of the wafer 100 and the workpiece film 110 obtained from the interference light 39sc between the reflected light 38s from the back surface of the wafer 100 and the reflected light 38c from the lower surface of the CVD-carbon layer 120.

Note that the CVD-carbon layer 120 has a property that both an extinction coefficient indicating an attenuation of light in a substance and a refractive index of light are large with respect to infrared light having a wavelength of 1200 nm or more. That is, the CVD-carbon layer 120 may function as a light shielding layer having a low transmittance of and a high reflectance, for example, with respect to infrared light.

For this reason, most of the light emitted from the light source 31 of the interferometer 3 to the back surface of the wafer 100 and transmitted through the wafer 100 and the workpiece film 110 is reflected at an interface between the workpiece film 110 and the CVD-carbon layer 120 without being transmitted through the upper surface of the workpiece film 110. Therefore, it is considered that the reflected light 38p from the lower surface of the workpiece film 110 is detected with relatively high intensity.

In addition, spectrum data obtained from the wafer 100 after a mask pattern 120p is formed by transferring the resist pattern 140p to the CVD-carbon layer 120 via the silicon oxynitride layer 130 is substantially similar to that obtained from the wafer 100 formed with the CVD-carbon layer 120 before the pattern is transferred thereto.

However, the mask pattern 120p has a plurality of openings. Therefore, the reflected light reflected without being transmitted through the upper surface of the workpiece film 110 includes light that have transmitted through the workpiece film 110, have reached non-opening portions of the mask pattern 120p, and have been reflected by the lower surface of the CVD-carbon layer 120 contacting the workpiece film 110, and light that have transmitted through the workpiece film 110, have reached the openings of the mask pattern 120p, and have been reflected by air or the like contacting the upper surface of the workpiece film 110 exposed from the openings.

This is considered to be the reason why the spectrum data obtained from the wafer 100 before the pattern is transferred to the CVD-carbon layer 120 does not completely match that after the pattern is transferred to the CVD-carbon layer 120.

In addition, after the plurality of through holes 111 are formed in the workpiece film 110 by etching through the mask pattern 120p, spectrum data having one peak near the optical path length of the wafer 100 is obtained from the wafer 100.

The front surface of the wafer 100 after the etching is partially exposed as compared with that in a state where the front surface of the wafer 100 is entirely covered with the workpiece film 110 before the etching. That is, the wafer 100 after the etching on the workpiece film 110 is in a state in which the state illustrated in Fig. 5B and the state illustrated in Fig. 5C are mixed.

For this reason, it is considered that spectrum data having one peak as illustrated in Fig. 5A is obtained, if two peak positions caused by the interference light 39sp and the interference light 39sc becomes close to each other by intensifying or weakening the interference light 39sp between the reflected light 38s from the back surface of the wafer 100 and the reflected light 38p from the lower surface of the workpiece film 110 and the interference light 39sc between the reflected light 38s from the back surface of the wafer 100 and the reflected light 38c from the lower surface of the CVD-carbon layer 120.

As described above, the spectrum data in the wafer 100 at each of the processing stages has a peak indicating an optical path length of the wafer 100 based on the interference light 39sp, and the spectrum data in the wafer 100 at some of the processing stages has a peak indicating a total optical path length of the wafer 100 and the workpiece film 110 based on the interference light 39sc.

As described above, since these two peak positions move, the film thickness difference of the workpiece film 110 within the plane of the wafer 100, for each wafer 100, or for each lot can be detected as, for example, an optical path length difference of the workpiece film 110 obtained from spectrum data.

However, the peak position, intensity, and the like of the spectrum are determined, with complicated factors including reflection and attenuation of light in each configuration, from the wafer 100 on which the workpiece film 110 and the like are formed. The workpiece film 110 itself has a multilayer structure including insulating layers NL and OL, and reflection and transmission are repeated for each of a large number of interfaces between the insulating layers NL and OL. The light having been repeatedly branched into transmission components and reflection components for all the layers as described above exhibits complicated behavior, which is also reflected in the peak position, the intensity, and the like of the spectrum data.

Therefore, the arithmetic device 30 of the interferometer 3 may have a database or the like of spectrum data for each film thickness of the workpiece film 110. In actually calculating a film thickness of the workpiece film 110, the arithmetic device 30 can identify the film thickness of the workpiece film 110 based on the spectrum data obtained from the wafer 100 to be measured while referring to the above-described database.

Thereafter, formation of various films, etching, and other processing are repeated to manufacture the semiconductor device according to the first embodiment. An example of a configuration of a semiconductor device 10 according to the first embodiment is illustrated in Fig. 6.

Fig. 6 is a cross-sectional view illustrating an example of a configuration of the semiconductor device 10 according to the first embodiment. However, in Fig. 1, hatching is omitted for easily viewing the drawing.

As illustrated in Fig. 6, the semiconductor device 10 includes an electrode layer EL, a source line SL, and a plurality of word lines WL in order from the lower side of the paper. In addition, the semiconductor device 10 includes a peripheral circuit CBA provided on a semiconductor substrate SB above the plurality of word lines WL. In the following description, the side on which the semiconductor substrate SB is disposed will be referred to as an upper side of the semiconductor device 10.

The source line SL is disposed on the electrode layer EL via an insulating film 160. A plurality of plugs PG are disposed in the insulating film 160, and the source line SL and the electrode layer EL maintain electrical conduction via the plugs PG. As a result, a source potential can be applied to the source line SL from the outside of the semiconductor device 10 via the electrode layer EL and the plugs PG.

The plurality of word lines WL is stacked on the source line SL. In the semiconductor device 10, a region where the plurality of word lines WL is arranged corresponds to an element region ER. A memory region MR is arranged at a central portion of each of the plurality of word lines WL, and step regions SR are arranged at both ends of the memory region MR.

Note that, although the semiconductor device 10 has only one stack structure of the word lines WL in the element region ER in the example of Fig. 6, the semiconductor device 10 may have a plurality of stack structures of the word lines WL each having a memory region MR and stepped regions SR in the element region ER.

In the memory region MR, a plurality of pillars PL penetrating the word lines WL in a stacking direction are arranged. A plurality of memory cells is formed at intersections between the pillars PL and the word lines WL. As a result, the semiconductor device 10 is configured as, for example, a three-dimensional nonvolatile memory in which memory cells are three-dimensionally arranged in the memory region MR.

In the step regions SR, the plurality of word lines WL is processed into a step shape and terminated. A contact CC connected to the word line WL of each layer is arranged in a terrace portion of each of the steps configured by the plurality of word lines WL.

The word lines WL stacked in multiple layers are individually drawn out by these contacts CC. From these contacts CC, a write voltage, a read voltage, and the like are applied to memory cells included in the memory region MR at the central portion of each of the plurality of word lines WL via the word line WL at the same height position as the memory cells.

The plurality of word lines WL, pillars PL, and contacts CC are covered with the insulating film 150. The insulating film 150 also extends around the plurality of word lines WL. The peripheral circuit CBA provided on the semiconductor substrate SB is disposed above the insulating film 150.

The semiconductor substrate SB is, for example, a silicon substrate or the like. The peripheral circuit CBA including a transistor TR, a wiring, and the like is disposed on the surface of the semiconductor substrate SB. Various voltages applied from the contacts CC to the memory cells are controlled by the peripheral circuit CBA electrically connected to the contacts CC. As a result, the peripheral circuit CBA controls the electrical operation of the memory cell.

The peripheral circuit CBA is covered with an insulating film 170, and the semiconductor device 10 including the plurality of word lines WL, pillars PL, contacts CC, and the like, and the peripheral circuit CBA is formed by bonding the insulating film 170 and the insulating film 150 covering the plurality of word lines WL to each other.

In manufacturing such a semiconductor device 10, a stacked body in which a plurality of silicon nitride layers and a plurality of silicon oxide layers are alternately stacked one by one is formed on a predetermined substrate via a source line SL.

In addition, etching is performed on a partial region of the stacked body in a stepwise manner to form a step region SR. In addition, memory holes for forming pillars PL are formed in the stacked body by the same etching, and the memory holes are filled with a memory layer, a semiconductor layer, and the like.

Thereafter, word lines WL are formed by processing for replacing the plurality of silicon nitride layers of the stacked body with conductive layers, which is called replacement processing. In addition, a contact CC is formed in the step region SR, and an upper layer wiring or the like is formed in an upper layer of the stacked body.

Here, at the time of performing the etching on the stacked body before the replacement processing, for example, plasma processing by the plasma processing apparatus 1 described above is used. That is, the stacked body before the replacement processing corresponds to the above-described workpiece film 110, and the silicon nitride layers NL and the silicon oxide layers OL of the workpiece film 110 are subjected to plasma processing to form a plurality of memory holes corresponding to the above-described through holes 111.

The substrate on which the stacked body is formed corresponds to the above-described wafer 100. The source line SL is formed, for example, by diffusing impurities on the surface of the wafer 100. Note that, even if another layer such as the source line SL is interposed between the wafer 100 and the workpiece film 110, a film thickness of the workpiece film 110 can be measured by the interferometer 3 as described above as long as the interposed layer is not a light shielding layer such as the CVD-carbon layer 120.

After the stacked body is subjected to replacement processing and an upper layer wiring or the like is formed on the stacked body, the semiconductor substrate SB on which the peripheral circuit CBA has been formed is bonded to the substrate on which the stacked body and the like are formed, that is, the wafer 100. Thereafter, the wafer 100 is removed by back grinding or the like, leaving the source line SL. Further, an insulating film 160 having plugs PG, an electrode layer EL, and the like are formed under the source line SL.

In this manner, the semiconductor device 10 according to the first embodiment is manufactured.

(Example of Plasma Processing)

Next, an example in which the wafer 100 is processed using the plasma processing apparatus 1 and the interferometer 3 according to the first embodiment will be described with reference to Fig. 7.

Fig. 7 is a flowchart illustrating an example of procedures for plasma processing on the wafer 100 according to the first embodiment. The flowchart of Fig. 7 illustrates procedures from an input of a lot until the input lot of wafers 100 is processed by the plasma processing apparatus 1.

As illustrated in Fig. 7, wafers 100 for one lot including a predetermined number of wafers 100 are input to the manufacturing process (step S101). Note that, in the process of manufacturing the semiconductor device 10, processing is advanced for each lot.

A workpiece film 110 in which a plurality of insulating layers NL and a plurality of insulating layers OL are alternately stacked one by one is formed on each of the wafers 100 for one lot (step S102). Further, a CVD-carbon layer 120 is formed on the workpiece film 110 (step S103) .

For example, a film thickness of the workpiece film 110 is measured, for example, by performing a measurement with respect to the wafer 100 using the interferometer 3 in a state where the CVD-carbon layer 120 is formed (step S104). At this time, as described above, with respect to one wafer 100, film thicknesses may be measured at a plurality of places in the plane of the wafer 100, and an average value or the like of a plurality of pieces of data obtained may be used as the film thickness of the workpiece film 110 in the wafer 100.

The film thickness of the workpiece film 110 is measured with respect to at least one wafer 100 among the wafers 100 for one lot. Alternatively, the measurement of the film thickness may be performed with respect to multiple wafers 100, such as a first wafer 100, a middle wafer 100, and a last wafer 100 of the lot. Alternatively, the measurement of the film thickness may be performed with respect to all of the wafers 100 for one lot.

After measuring the film thickness of the workpiece film 110, a silicon oxynitride layer 130 is formed on the CVD-carbon layer 120 (step S105), and a resist pattern 140p is further formed on the silicon oxynitride layer 130 (step S106).

For each wafer 100, etching is performed on the silicon oxynitride layer 130 using the resist pattern 140p as a mask (step S107), and etching is performed on the CVD-carbon layer 120 using the silicon oxynitride layer 130 to which the resist pattern 140p has been transferred as a mask (step S108). As a result, a mask pattern 120p is formed on each wafer 100 by transferring the pattern to the CVD-carbon layer 120.

For each wafer 100, etching is performed on the workpiece film 110 exposed from the mask pattern 120p (step S109). At this time, an etching condition such as an etching time is adjusted based on the film thickness of the workpiece film 110 measured by the interferometer 3 so that the workpiece film 110 is appropriately penetrated.

In a case where the measurement of the film thickness is performed with respect to one wafer 100, the film thickness of the workpiece film 110 for the wafer 100 is used as a representative value, and is applied to all of the wafers 100 for one lot.

In a case where the measurement of the film thickness is performed with respect to a plurality of wafers 100, an average value of a plurality of film thickness values obtained from these wafers 100 may be applied to all of the wafers 100 for one lot. Alternatively, the wafers 100 for one lot can be divided into groups according to the number of wafers 100 for which the measurement of the film thickness has been performed, and for example, a film thickness obtained from a first wafer 100 of the lot can be applied to wafers 100 on the front side, a film thickness obtained from a middle wafer 100 of the lot can be applied to wafers 100 near the center, and a film thickness obtained from a last wafer 100 of the lot can be applied to wafers 100 on the rear side.

In a case where the measurement of the film thickness is performed with respect to all of the wafers 100 for one lot, an etching condition based on the corresponding film thickness can be applied to each wafer 100.

During the etching, the controller 50 determines whether a time to terminate the etching of the workpiece film 110 has been reached under the etching condition corresponding to the film thickness of the workpiece film 110 (step S110).

The controller 50 continues the etching until the time to terminate the etching of the workpiece film 110 is reached (step S110: No) (step S109). When the time to terminate the etching of the workpiece film 110 is reached (step S110: Yes), the controller 50 stops the power supply into the chamber 11.

Then, the plasma processing on the wafer 100 according to the first embodiment ends.

(Overview)

In a process of manufacturing a semiconductor device, etching may be performed on a workpiece film using a plasma processing apparatus. The etching on the workpiece film is performed using an etching condition that is appropriately determined in advance.

However, at the time of forming a workpiece film on each wafer, a film thickness of the workpiece film is controlled by, for example, a periodic quality control, but the film thickness of the workpiece film may vary for each wafer or for each lot. In a case where the workpiece film has a multilayer structure in which a plurality of different kinds of layers are stacked, the variation in film thickness between the lots is, for example, about ±10%.

If the etching is uniformly performed on such workpiece films using the same condition, in a case where an actual film thickness of a workpiece film is thicker than a target film thickness, the etching is terminated without reaching a desired etching depth. In addition, in a case where an actual film thickness of a workpiece film is thinner than a target film thickness, excessive over-etching may cause the base film of the workpiece film to be etched away, or change the processed shape of the workpiece film such as expansion of dimension.

Therefore, as an example of a countermeasure, a change in emission wavelength may be monitored during plasma processing and an end point may be detected in real time. However, in a case where the etching area exposed from the mask pattern, that is, the coverage of the mask pattern, is small in a certain etching condition or the like, it is not possible to sufficiently grasp a change in wavelength, and accordingly, it is not possible to detect an end point.

In addition, as an example of a countermeasure, it may also be considered to measure a film thickness using an optical film thickness meter such as an ellipsometer after a workpiece film is formed, and adjust an etching condition such as an etching time based on the measurement result. However, in a case where the workpiece film has, for example, a multilayer structure in which a plurality of different kinds of layers are stacked, and the total number of layers exceeds 100, it is difficult to accurately measure the film thickness using the optical film thickness meter.

In the method for manufacturing the semiconductor device according to the first embodiment, the back surface of the wafer 100 is irradiated with light, and a thickness of the workpiece film 110 is calculated based on interference light 39sp generated by interference between reflected light 38s reflected by the back surface of the wafer 100 and reflected light 38p transmitted through the wafer 100 and reflected by the lower surface of the workpiece film 110, and interference light 39sc generated by interference between the reflected light 38s and reflected light 38c transmitted through the wafer 100 and the workpiece film 110 and reflected by the lower surface of the CVD-carbon layer 120.

As a result, the film thickness of the workpiece film 110 can be measured with high accuracy. By measuring the film thickness using the interferometer 3 as described above, film thickness information regarding the workpiece film 110 on the wafer 100 can be acquired with high accuracy.

In the method for manufacturing the semiconductor device according to the first embodiment, etching is performed, under an etching condition based on the thickness of the workpiece film 110 calculated from the interference light 39sp and the interference light 39sc, so that the workpiece film 110 exposed from the mask pattern 120p is penetrated.

As a result, the processing can be performed on the workpiece film 110 that varies in film thickness for each wafer 100 or for each lot under the appropriate etching condition.

In the method for manufacturing the semiconductor device according to the first embodiment, at the time of forming the mask pattern 120p, a pattern is formed on the CVD-carbon layer 120 that shields the light emitted to the wafer 100 as the mask pattern 120p. As a result, the intensity of the reflected light 38sc transmitted through the wafer 100 and the workpiece film 110 and reflected without being transmitted through the upper surface of the workpiece film 110 can be increased, and the accuracy in the measurement of the film thickness can be increased.

In the method for manufacturing the semiconductor device according to the first embodiment, the workpiece film 110 is a film in which a plurality of insulating layers NL and a plurality of insulating layers OL are alternately stacked one by one, and the plurality of insulating layers NL included in the workpiece film 110 is 50 or more layers. Therefore, the number of the two types of insulating layers NL and OL included in the workpiece film 110 is 100 or more.

As described above, even in a case where the workpiece film 110 has a multilayer structure and it is difficult to measure a film thickness using an optical film thickness meter, the film thickness of the workpiece film 110 can be measured with high accuracy by using the interferometer 3. In addition, for example, even in a case where it is difficult to detect an end point by observation of plasma emission, an etching condition such as an etching time can be optimized by measuring a film thickness of the workpiece film 110 using the interferometer 3.

In the first embodiment described above, after the CVD-carbon layer 120 is formed on the workpiece film 110, a film thickness of the workpiece film 110 is measured by the interferometer 3. However, the film thickness of the workpiece film 110 may be measured, for example, at a timing after the workpiece film 110 is formed and before the CVD-carbon layer 120 is formed.

Transmission and reflection of light occur at an interface between substances having different refractive indexes. Therefore, after the workpiece film 110 is formed, even in a state where the upper surface of the workpiece film 110 is in contact with an atmosphere in a measurement environment such as air, the film thickness of the workpiece film 110 can be measured using the interferometer 3.

The film thickness of the workpiece film 110 may be measured at any timing after the CVD-carbon layer 120 is formed, after the silicon oxynitride layer 130 is formed, after the resist pattern 140p is formed, after the etching is performed on the silicon oxynitride layer 130, or after the etching is performed on the CVD-carbon layer 120.

In this manner, the film thickness of the workpiece film 110 can be measured at any timing after the workpiece film 110 is formed and before the etching on the workpiece film 110 is started.

Note that, in a case where the measurement of the film thickness is performed after another layer is further formed on the workpiece film 110, a layer functioning as a light shielding layer is preferably formed at least immediately on the workpiece film 110.

For example, the CVD-carbon layer 120 has properties as a light shielding layer as described above. Therefore, even in a case where the silicon oxynitride layer 130, the resist pattern 140p, and the like are formed on the CVD-carbon layer 120, the amount of light transmitted through these layers is extremely small, and it is considered that these layers have little influence on the measurement of the film thickness of the workpiece film 110.

In addition, the layer functioning as a light shielding layer may be a titanium layer, a tungsten layer, or a nitride layer of a carbon-based material, titanium, or tungsten, as well as the carbon-based layer such as the CVD-carbon layer 120 described above.

In the first embodiment described above, the interference light 39sp between the reflected light 38s and the reflected light 38p from the front and back surfaces of the wafer 100 is measured from the wafer 100 on which the workpiece film 110 and the like are formed, and the influence of the wafer 100 on the interference light 39sc obtained from the workpiece film 110 is estimated.

However, for example, an interference spectrum of the wafer 100 alone can be obtained by performing a measurement in a state where the wafer 100 is alone before the workpiece film 110 is formed using the interferometer 3. A film thickness of the workpiece film 110 may be measured from a result of analyzing the interference spectrum of the wafer 100 alone and the interference spectrum obtained from the wafer 100 on which the workpiece film 110 and the like are formed.

It is considered that a silicon wafer or the like used for manufacturing a semiconductor device is subjected to strict quality control, and there are almost no variations in various specifications of the silicon wafer including a thickness. However, even in this case, it is considered that the film thickness of the workpiece film 110 can be measured more reliably and more accurately by referring to not only the interference spectrum of the wafer 100 after the workpiece film 110 is formed but also the interference spectrum of the wafer 100 alone.

The measurement in a state where the wafer 100 is alone can be performed at a plurality of places in the plane of the wafer 100 for one wafer 100, for example, when a lot is input. In addition, the measurement in a state where the wafer 100 is alone can be performed for one or more wafers 100 included in the lot. All of the wafers 100 in the lot may be inspected.

Furthermore, in the first embodiment described above, the etching processing is performed to obtain a desired processed shape, for example, by changing the etching time based on the film thickness of the workpiece film 110 obtained by the interferometer 3. However, the etching conditions include various parameters capable of controlling an etching rate and a processed shape, such as a pressure, a radio frequency power value, a type and a flow rate of a processing gas, and a wafer temperature.

Therefore, when the etching condition is changed based on the film thickness of the workpiece film 110, other parameters may be changed instead of or in addition to the etching condition.

[Second Embodiment]

Hereinafter, a second embodiment will be described in detail with reference to the drawings. The second embodiment is different from the first embodiment in that a wafer temperature is measured using interference light during plasma processing. In the drawings to be mentioned below, the same reference signs will be given to components that are the same as those in the first embodiment described above, and the description thereof may be omitted.

(Example of Configuration of Plasma Processing Apparatus)

Fig. 8 is a cross-sectional view schematically illustrating an example of a configuration of a plasma processing apparatus 2 according to the second embodiment. The plasma processing apparatus 2 according to the second embodiment includes components corresponding to the respective components of the interferometer 3 according to the first embodiment described above.

That is, the plasma processing apparatus 2 includes a light source 231, an optical coupler 232, a collimator lens 233, a sensor head 235, a spectroscope 236, and an optical fiber cable 237 as a configuration corresponding to the interferometer 3 according to the first embodiment described above. In addition, the plasma processing apparatus 2 includes an electrostatic chuck 220 and a controller 250 instead of the electrostatic chuck 20 and the controller 50 according to the first embodiment described above.

Similarly to the interferometer 3 according to the first embodiment described above, the optical fiber cable 237 connects the light source 231, the optical coupler 232, the collimator lens 233, the sensor head 235, and the spectroscope 236 to each other. The sensor head 235 is inserted into a through hole provided in the electrostatic chuck 220 in the chamber 11 of the plasma processing apparatus 2.

Thus, the back surface of the wafer 200 placed on the electrostatic chuck 220 can be irradiated with light from the light source 231 via the sensor head 235. In addition, interference light from each part of the wafer 200 is emitted to the spectroscope 236 via the sensor head 235 and the collimator lens 233, and the spectroscope 236 outputs an interference spectrum obtained by analyzing the interference light to the controller 250.

By using the interference spectrum obtained as described above, a temperature of a substance such as the wafer 200 made of a known material and having a known thickness can be calculated.

The controller 250 of the plasma processing apparatus 2 also has a function as an arithmetic device that analyzes the interference spectrum from the spectroscope 236. Therefore, the controller 250 analyzes the interference spectrum of the wafer 200 output from the spectroscope 236 and calculates a temperature of the wafer 200 during the plasma processing in the plasma processing apparatus 2.

(Example of Configuration of Electrostatic Chuck)

Next, a temperature adjustment mechanism of the electrostatic chuck 220 will be described with reference to Figs. 9A and 9B.

Figs. 9A and 9B are schematic views illustrating an example of a temperature adjustment mechanism of the electrostatic chuck 220 included in the plasma processing apparatus 2 according to the second embodiment. Fig. 9A is a top view of the electrostatic chuck 220, and Fig. 9B is a schematic view of the temperature adjustment mechanism including a cross section of the electrostatic chuck 220. In Figs. 9A and 9B, a through hole into which the sensor head 235 is inserted is omitted.

As illustrated in Figs. 9A and 9B, the electrostatic chuck 220 of the plasma processing apparatus 2 includes a main body 21, a chuck part 22, and a ceramic plate 23. The main body 21 serves as a base of the electrostatic chuck 220. The chuck part 22 includes the above-described chuck electrode 24, etc. and is disposed on the main body 21. The ceramic plate 23 is disposed on the outermost surface of the electrostatic chuck 220 and serves as a surface for placing the wafer 200.

In addition, the electrostatic chuck 220 includes a refrigerant flow path 25 and a gas flow path 28 that constitute some of the temperature adjustment mechanism. In addition to the refrigerant flow path 25 and the gas flow path 28, the electrostatic chuck 220 is provided with a chiller 82, a gas supply pipe 81, a mass flow controller (MFC) 83, a valve 84, a tank 85, and temperature sensors 86 and 87 as the temperature adjustment mechanism.

The chiller 82 is connected to the main body 21 of the electrostatic chuck 220, and is configured to be able to circulate the refrigerant controlled to a predetermined temperature in the electrostatic chuck 220. That is, the refrigerant is discharged from a discharge port of the chiller 82 toward the electrostatic chuck 220 and flows into an introduction port of the chiller 82, thereby circulating between the chiller 82 and the electrostatic chuck 220. As the refrigerant, for example, a fluorinated hydrocarbon such as ethylene glycol, water, or another liquid is used according to a desired temperature range.

The refrigerant flow path 25 is provided at a predetermined depth position inside the main body 21 of the electrostatic chuck 220 along the surface of the electrostatic chuck 220, that is, along the ceramic plate 23, which is a surface for placing the wafer 200. The refrigerant flow path 25 may have any design such as meandering inside body 21 or branched into a plurality of paths inside the main body 21. The refrigerant flow path 25 may include a plurality of independent flow paths.

The temperature sensor 87 is provided on the inlet side of the refrigerant flow path 25 to the main body 21, and the temperature sensor 86 is provided on the outlet side of the refrigerant flow path 25. The chiller 82 controls a temperature of the refrigerant based on the detection results of the temperature sensors 86 and 87.

The gas flow path 28 is provided to penetrate the electrostatic chuck 220, and has a plurality of openings 28g open to the surface of the ceramic plate 23. The plurality of openings 28g are provided in a distributed manner over the entire surface of the ceramic plate 23. In a case where the refrigerant flow path 25 includes a plurality of independent flow paths, the gas flow path 28 may also include a plurality of independent flow paths.

A downstream end of the gas supply pipe 81 having an upstream end to which the gas supply source CY is connected is connected to an upstream end of the gas flow path 28. The gas supply source CY stores a gas having high thermal conductivity, such as a He gas or an Ar gas. The gas supply pipe 81 is provided with an MFC 83, a valve 84, and a tank 85 in this order from the upstream side. The tank 85 is provided with a pressure sensor 85p that measures a pressure in the tank 85.

By opening the valve 84 of the gas supply pipe 81, the flow rate of the gas flowing out of the gas supply source CY is controlled by the MFC 83, the gas is once stored in the tank 85 and the pressure of the gas is adjusted, and the gas is diffused between the front surface of the ceramic plate 23 and the back surface of the wafer 200 from the plurality of openings 28g of the ceramic plate 23.

The controller 250 of the plasma processing apparatus 2 controls the pressure in the tank 85 by changing the gas flow rate by the MFC 83 based on the measurement result of the pressure sensor 85p. As a result, the gas temporarily stored in the tank 85 is supplied to the plurality of openings 28g of the ceramic plate 23 at a predetermined pressure.

As described above, the gas flow path 28 through which the gas having high thermal conductivity flows is disposed in the vicinity of the refrigerant flow path 25 through which the temperature-controlled refrigerant flows, on the side closer to the ceramic plate 23, which is a surface for placing the wafer 200, than the refrigerant flow path 25.

As a result, heat exchange is performed between the refrigerant flowing through the refrigerant flow path 25 and the gas flowing through the gas flow path 28, and the gas is controlled to a predetermined temperature. The gas controlled to the predetermined temperature is diffused to the back surface of the wafer 200, so that the temperature of the wafer 200 can be adjusted.

In a case where each of the refrigerant flow path 25 and the gas flow path 28 includes a plurality of independent flow paths as described above, the electrostatic chuck 220 may be divided into a plurality of zones and adjusted to different temperatures for the respective zones.

(Method for Manufacturing Semiconductor Device)

Next, an example of a method for manufacturing a semiconductor device according to the second embodiment will be described with reference to Figs. 10A to 14B. The method for manufacturing the semiconductor device according to the second embodiment includes plasma processing on the wafer 200 in the plasma processing apparatus 2 described above.

Figs. 10A to 12B are cross-sectional views sequentially exemplifying some procedures for the method for manufacturing the semiconductor device according to the second embodiment. Figs. 10A to 12B mainly illustrate a state from an input of a lot until etching processing is performed by the plasma processing apparatus 2.

As illustrated in Figs. 10A to 10C, in the method for manufacturing the semiconductor device according to the second embodiment, a plurality of light shielding layers 210 are formed on the front surface of the wafer 200 after the lot is input.

That is, as illustrated in Fig. 10A, a plurality of recesses 201 are formed on the front surface of the wafer 200. The plurality of recesses 201 have areas substantially equal to each other in the top view in a region vertically overlapping the back surface of the wafer 200 of a portion to be irradiated with light via the sensor head 235 later, and are periodically arranged at predetermined intervals. At this time, the distance between the plurality of recesses 201 is set to be smaller than the wavelength of light to be emitted to the back surface of the wafer 200 later.

As illustrated in Fig. 10B, the plurality of recesses 201 are filled with a CVD-carbon layer. As a result, a plurality of light shielding layers 210 periodically arranged at predetermined intervals are formed in the region of the front surface of the wafer 200 corresponding to the back surface of the wafer 200 of the portion irradiated with light later.

The shape of the plurality of light shielding layers 210 as viewed from above, for example, a circular shape, an oval shape, an elliptical shape, a polygonal shape, or the like. At this time, the plurality of light shielding layers 210 can be arranged in, for example, a hexagonal close-packed lattice pattern such that the interval between the plurality of light shielding layers 210 is smaller than the wavelength of light.

However, the plurality of recesses 201 and the plurality of light shielding layers 210 may be formed over the entire surface of the wafer 200.

As illustrated in Fig. 10C, a workpiece film 110 in which a plurality of insulating layers NL and OL (see Fig. 3A described above) are alternately stacked one by one is formed on the wafer 200. Thus, the plurality of light shielding layers 210 formed on the front surface of the wafer 200 are covered with the workpiece film 110. As described above, for example, the light shielding layers 210 are not formed to cover the entire front surface of the wafer 200, and are arranged at predetermined intervals, so that the peeling of the workpiece film 110 can be suppressed.

Further, a CVD-carbon layer 120, a silicon oxynitride layer 130, and a resist pattern 140p are formed in this order on the workpiece film 110.

As illustrated in Fig. 11A, the silicon oxynitride layer 130 and the CVD-carbon layer 120 are sequentially etched to form a mask pattern 120p of the CVD-carbon layer 120 to which the resist pattern 140p has been transferred.

As illustrated in Fig. 11B, etching on the workpiece film 110 is started using the plasma processing apparatus 2. That is, a wafer 200 is carried into the chamber 11 of the plasma processing apparatus 2 and placed on the electrostatic chuck 220. Further, plasma P is generated in the chamber 11 while the back surface of the wafer 200 is irradiated with light from the light source 231 via the sensor head 235 downward of the electrostatic chuck 220.

As a result, etching on the workpiece film 110 is started in portions exposed from the openings of the mask pattern 120p.

As illustrated in Fig. 12A, the etched depth of the workpiece film 110 increases as the plasma processing is continued by the plasma processing apparatus 2.

As illustrated in Fig. 12B, after a predetermined time elapses, the exposed portions of the workpiece film 110 are penetrated, and a plurality of through holes 111 are formed. The light shielding layers 210 or the front surface of the wafer 200 is exposed on the bottom surfaces of the through holes 111.

Here, during the etching on the workpiece film 110, the wafer 200 is exposed to high-temperature plasma. During the plasma processing, the temperature of the wafer 200 is controlled by the electrostatic chuck 220 of the plasma processing apparatus 2 so that the temperature of the wafer 200 is kept constant, but the temperature of the wafer 200 gradually increases due to heat from the plasma.

A part of the light with which the back surface of the wafer 200 is irradiated is reflected by the back surface of the wafer 200 and detected by the sensor head 235 as reflected light 238s. In addition, another part of the light with which the back surface of the wafer 200 is irradiated is transmitted through the wafer 200, reflected by the back surface of the light shielding layer 210, and detected by the sensor head 235 as reflected light 238b.

The above-described spectroscope 236 measures a spectrum of an interference wave obtained by interference between the reflected light 38s and the reflected light 38b. The controller 250 of the plasma processing apparatus 1 performs various calculations based on the interference spectrum measured by the spectroscope 236 to calculate a temperature of the wafer 200 during the plasma processing.

That is, an optical path length of the wafer 200 is obtained from interference light 39sb between the reflected light 38s from the back surface of the wafer 200 and the reflected light 38b from the bottom surface, also referred to as the lower surface of the light shielding layer 210. As described above, the optical path length is expressed as a product of a refractive index of a target substance and a distance by which light travels in the substance, that is, a thickness of the substance. In addition, both the refractive index and the thickness of the substance change depending on the temperature of the substance at that time.

Therefore, when the temperature of the wafer 200 changes during the plasma processing, the optical path length of the wafer 200 also changes. Therefore, when the refractive index and the thickness at each temperature are known like those of the wafer 200 used for manufacturing a semiconductor device, the temperature of the wafer 200 at that time can be obtained from the optical path length of the wafer 200.

In the temperature measurement using such interference light, the interval between the plurality of light shielding layers 210 is preferably smaller than the wavelength of the light with which the back surface of the wafer 200 is irradiated as described above. As a result, in a region where the pattern of the mask pattern 120p is formed and the workpiece film 110 is etched, light is shielded by any one of the plurality of light shielding layers 210, rather than passing between the plurality of light shielding layers 210 being transmitted through the workpiece film 110, and is detected by the sensor head 235 as reflected light 238b.

In a region where the pattern of the mask pattern 120p is formed and the workpiece film 110 is etched, if a part of light is transmitted through the workpiece film 110, the other part of the light can be reflected by an etched end of the workpiece film 110 and detected by the sensor head 235 as reflected light 238p.

As illustrated in Figs. 11B to 12B, the depth reached by the etched end in the workpiece film 110 changes over time. For this reason, the reflected light 238p at the etched end and the interference light between the reflected light 238p and other reflected light from each portion of the wafer 200, such as the reflected light 238s and the reflected light 238b, also change over time, and may become disturbing factors in calculating the temperature of the wafer 200.

By arranging the plurality of light shielding layers 210 at intervals smaller than the wavelength of light, such disturbing factors can be eliminated in advance.

Note that, in the processing of Figs. 10A and 10B described above, when a plurality of light shielding layers 210 are formed, in a region where the pattern of the mask pattern 120p is formed and the workpiece film 110 is etched, the light shielding layers 210 having an area slightly larger than the size of the plurality of through holes 111 may be disposed at positions vertically overlapping the through holes 111 in the top view.

As a result, the bottom surfaces of the through holes 111 entirely reach the light shielding layers 210, making it easy for the workpiece film 110 to have uniform etching characteristics, and for the through holes 111 to have a uniform processed shape.

In a case where the through holes 111 of the workpiece film 110 are, for example, memory holes or the like for forming the pillars PL of the semiconductor device 10 according to the first embodiment described above, these through holes 111 are densely arranged, for example, in a staggered manner in the top view. Therefore, in a case where the plurality of light shielding layers 210 are arranged to correspond to the positions at which these through holes 111 are formed, the interval between the light shielding layers 210 can be smaller than the wavelength of light.

In addition, in a case where the through holes 111 are memory holes or the like for forming pillars PL, the light shielding layers 210 exposed on the bottom surfaces of the through holes 111 can be removed by etching or ashing after the through holes 111 are formed.

Here, preferable characteristics of the light shielding layers 210 will be discussed.

Fig. 13 is a schematic diagram illustrating a light shielding layer 210 and components positioned on and under the light shielding layer 210 according to the second embodiment. As illustrated in Fig. 13, refractive indexes of the wafer 200, the light shielding layer 210, and the workpiece film 110 are denoted by $n_0$, $n_2$, and $n_2$, respectively, and extinction coefficients of the wafer 200, the light shielding layer 210, and the workpiece film 110 are $k_0$, $k_1$, and $k_2$, respectively.

Transmittances of light incident from the light source 231 to the wafer 200, the light shielding layer 210, and the workpiece film 110, that is, transmittances of light in the air, the wafer 200, and the light shielding layer 210 are denoted by $T_0$, $T_2$, and $T_2$, respectively. In addition, reflectances of the light at an interface between the wafer 200 and the light shielding layer 210 and an interface between the light shielding layer 210 and the workpiece film 110 are denoted by $R_0$ and $R_2$, respectively.

In this case, when the transmittance $T_0$ of the light incident on the wafer 200 in the air is 1 ($T_0$=1), the transmittance $T_1$ in the wafer 200 can be expressed by the following Formula (1).

$$T_1=T_0-R_0=1-R_0 \quad \cdots \quad (1)$$

Furthermore, in consideration of the attenuation of the light in the light shielding layer 210, the transmittance $T'_1$ of the light incident on the light shielding layer 210 can be expressed by the following Formula (2) using a layer thickness d and an absorption coefficient $\alpha$ of the light shielding layer 210. In Formula (2), e is the base of the natural logarithm.

$$T'_1=(1-R_0)e^{-\alpha d} \quad \cdots \quad (2)$$

The reflectances $R_0$ and $R_1$ at the interface between the wafer 200 and the light shielding layer 210 and at the interface between the light shielding layer 210 and the workpiece film 110 are expressed by the following Formulas (3) and (4), respectively.

$$R_0 = \left(\frac{n_1 - n_0}{n_1 + n_0}\right)^2 \quad \cdots (3)$$

$$R_1 = T'_1 \cdot \left(\frac{n_2 - n_1}{n_2 + n_1}\right)^2 \quad \cdots (4)$$

From the above, when the absorption coefficient $\alpha$ of the light shielding layer 210 is $\alpha=4\pi k_1/\lambda$ using a wavelength $\lambda$ of the light, the transmittance $T_2$ in the light shielding layer 210 of the light incident on the workpiece film 110 can be expressed by the following Formula (5).

$$T_2 = T_1' - R_1 = \left\{1 - \left(\frac{n_1 - n_0}{n_1 + n_0}\right)^2\right\}\left\{1 - \left(\frac{n_2 - n_1}{n_2 + n_1}\right)^2\right\} e^{-\frac{4\pi k_1 d}{\lambda}}$$

$\lambda$ : *WAVELENGTH*

$d$ : *LAYER THICKNESS OF LIGHT SHIELDING LAYER*

$n_i$ : *REFRACTIVE INDEX OF LIGHT SHIELDING LAYER OR LAYER LOCATED ON OR UNDER LIGHT SHIELDING LAYER*

$k_1$ : *EXTINCTION COEFFICIENT OF LIGHT SHIELDING LAYER*

$\cdots (5)$

As described above, the transmittance $T_2$ of the light in the light shielding layer 210 depends on the physical property values of the light shielding layer 210, such as the absorption coefficient $\alpha$ and the extinction coefficient $k_1$, and the layer thickness. In the configuration according to the second embodiment, the light shielding layer 210 having physical properties and a layer thickness such that the transmittance $T_2$ in the light shielding layer 210 is less than 20%, more preferably less than 10% can be used. In this case, the light is incident on the light shielding layer 210 from the wafer 200 and from the workpiece film 110, and reciprocates through the light shielding layer 210, so that the intensity of the light returned to the sensor head 235 is attenuated to less than 4%. Therefore, it can be said that light from the workpiece film 110 is sufficiently shielded by such a light shielding layer 210.

As an example, in a case where the light shielding layer 210 is a CVD-carbon layer, and the light shielding layer 210 having a layer thickness of 400 nm is irradiated with light having a wavelength of 1310 nm, the transmittance $T_2$ of the light shielding layer 210 is 7.0247%. In addition, in a case where light having a wavelength of 1310 nm is irradiated, the light shielding layer 210 can have a dimension of 100 nm and a pitch of 150 nm in the top view.

In a state where the light shielding layer 210 selected as described above shields the influence of the light on the side of the workpiece film 110, the temperature of the wafer 200 can be calculated by a measurement using the interference light during plasma processing. As described above, the optical path length of the wafer 200 is expressed as a product of a refractive index of silicon or the like constituting the wafer 200 and a thickness of the wafer 200, and both the refractive index and the thickness are expressed as a function of the temperature of the wafer 200.

Figs. 14A and 14B are schematic diagrams each illustrating a state of the wafer 200 during plasma processing according to the second embodiment. Fig. 14A illustrates the wafer 200 in a low temperature state, and Fig. 14B illustrates wafer the 200 in a high temperature state.

As illustrated in Figs. 14A and 14B, during the plasma processing, the temperature of the wafer 200 gradually rises, and the wafer 200 expands accordingly. As a result, the thickness of the wafer 200 and the distance by which light transmitted through the wafer 200 and reflected by the front surface of the wafer 200 travels in the wafer 200 vary between the low temperature state and the high temperature state.

In the measurement using the interference light, such a difference is detected as an optical path length difference corresponding to the temperature of the wafer 200. Since the material and the original thickness of the wafer 200 are known, it is possible to detect a temperature change of the wafer 200 during plasma processing based on a change in optical path length of the wafer 200 by adding a change in refractive index corresponding to the temperature change to the thermal expansion coefficient of the wafer 200.

In order to keep the temperature of the wafer 200 exposed to high-temperature plasma constant during the etching of the workpiece film 110, the refrigerant controlled to a predetermined temperature by the chiller 82 is circulated in the refrigerant flow path 25 of the electrostatic chuck 220. In addition, a gas having high thermal conductivity such as a He gas controlled to a predetermined temperature by heat exchange with the refrigerant is supplied from the gas supply source CY to the back surface of the wafer 200 placed on the electrostatic chuck 220 via the MFC 83, the tank 85, and the openings 28g of the gas flow path 28. As a result, the temperature of the wafer 200 is controlled to a desired temperature.

However, as described above, as the plasma processing proceeds, the temperature of the wafer 200 gradually increases due to the heat from the plasma. The controller 250 of the plasma processing apparatus 2 increases the gas pressure to be supplied to the back surface of the wafer 200, for example, based on the temperature of the wafer 200 measured as described above.

Specifically, the controller 250 increases the flow rate of the gas flowing into the tank 85 by the MFC 83 to increase the pressure in the tank 85. As a result, the pressure of the gas supplied to the back surface of the wafer 200 increases, such that the temperature of the wafer 200 can be lowered.

By controlling the temperature of the wafer 200 by the electrostatic chuck 220 or the like based on the temperature measurement result as described above, it is easy to suppress an increase in temperature of the wafer 200 during plasma processing and to maintain the temperature of the wafer 200 substantially constant.

Then, the etching on the workpiece film 110 by the plasma processing apparatus 2 according to the second embodiment ends.

Thereafter, by repeating formation of various films, etching, and other processing, for example, a semiconductor device similar to that of the first embodiment described above is manufactured.

(Example of Plasma Processing)

Next, an example in which the wafer 200 is processed using the plasma processing apparatus 2 according to the second embodiment will be described with reference to Fig. 15.

Fig. 15 is a flowchart illustrating an example of procedures for plasma processing on the wafer 200 according to the second embodiment. The flowchart of Fig. 15 illustrates procedures from an input of a lot until the input lot of wafers 200 is processed by the plasma processing apparatus 2.

As illustrated in Fig. 15, wafers 200 for one lot including a predetermined number of wafers 200 are input to the manufacturing process (step S201).

A plurality of light shielding layers 210 periodically arranged at predetermined intervals are formed on the front surface of each of the wafers 200 for one lot (step S202).

In addition, a workpiece film 110 in which a plurality of insulating layers NL and a plurality of insulating layers OL are alternately stacked one by one is formed on each of the wafers 200 (step S203). Thus, the plurality of light shielding layers 210 formed on the front surface of the wafer 200 are covered by the workpiece film 110.

Further, a CVD-carbon layer 120 is formed on the workpiece film 110 (step S204), a silicon oxynitride layer 130 is formed on the CVD-carbon layer 120 (step S205), and a resist pattern 140p is further formed on the silicon oxynitride layer 130 (step S206).

For each wafer 100, etching is performed on the silicon oxynitride layer 130 using the resist pattern 140p as a mask (step S207), and etching is performed on the CVD-carbon layer 120 using the silicon oxynitride layer 130 to which the resist pattern 140p has been transferred as a mask (step S208). As a result, a mask pattern 120p is formed by transferring the pattern to the CVD-carbon layer 120.

For each wafer 100, etching is performed on the workpiece film 110 exposed from the mask pattern 120p. At this time, the controller 250 irradiates the back surface of the wafer 200 with light during plasma processing, monitors a temperature of the wafer 200 in plasma (step S209), and determines whether the temperature of the wafer 200 is changed (step S210).

When the temperature of the wafer 200 has been changed (step S210: Yes), the controller 250 changes, for example, a pressure at which a gas such as a He gas is supplied to the electrostatic chuck 220, so that the wafer 200 is maintained at a desired temperature (step S211). When the wafer 200 is maintained at the desired temperature (step S210: No), the feedback control of step S211 is not performed, and the pressure at which the gas is supplied to the electrostatic chuck 220 remains unchanged.

Furthermore, the controller 250 continues the etching (step S209) until a time to terminate the etching of the workpiece film 110 is reached (step S212: No). When the time to terminate the etching is reached (step S212: Yes), the power supply into the chamber 11 is stopped.

Then, the plasma processing on the wafer 200 according to the second embodiment ends.

(Overview)

When the etching on the workpiece film is performed using the plasma processing apparatus, if the temperature of the wafer is changed due to exposure to high-temperature plasma, an etching rate and a processed shape of the workpiece film is also changed. For this reason, for example, the temperature of the electrostatic chuck is monitored during plasma processing, and the temperature of the wafer is feedback-controlled. However, there is a difference of 10°C or more between the temperature of the electrostatic chuck and the actual temperature of the wafer, and it is difficult to control the temperature with sufficiently high accuracy.

Therefore, for example, a method of simulatively measuring a temperature change of a wafer during plasma processing using a temperature measurement wafer may be adopted. When an actual wafer is processed, the temperature of the wafer is controlled based on a temperature measurement result acquired in advance. However, the temperature measurement wafer is thicker than the actual wafer by 1.2 mm to 1.4 mm due to its structure, and it cannot be said that the measurement value obtained by the temperature measurement wafer is sufficiently accurate. In addition, in recent years, an etching technique may be used under a cryogenic temperature of less than -10°C, and an existing temperature measurement wafer has a disadvantage in that a temperature measurement cannot be performed at a low temperature of less than -10°C.

For this reason, in recent years, there has been studied a technique of estimating a temperature of a wafer by observing interference between reflected beams such as laser beams emitted to the wafer using a phenomenon in which the optical path length of the wafer changes depending on the temperature of the wafer. However, in a wafer on which a thick workpiece film having a stack structure is formed, the observation of the optical path length of the wafer is affected by a variation in film thickness of the workpiece film. In addition, when etching is performed on such a workpiece film, in the process of forming a predetermined shape of the workpiece film, the observed optical path length of the wafer also varies depending on the processed shape. As described above, even in a measurement method using interference light, it may be difficult to accurately estimate a temperature of the wafer.

In the method for manufacturing the semiconductor device according to the second embodiment, a back surface of the wafer 200 is irradiated with light while etching the workpiece film 110, interference light 239sb is observed, the interference light 239sb being generated by interference between reflected light 238s reflected by the back surface of the wafer 200 and reflected light 238b transmitted through the wafer 200 and reflected by lower surfaces of the plurality of light shielding layers 210, and a temperature of the wafer 200 is calculated during etching processing based on the interference light 239sb.

By forming the plurality of light shielding layers 210 that shields light having a predetermined wavelength on the front surface of the wafer 200 at predetermined intervals as described above, it is possible to shield the influence of light on the side of the workpiece film 110 and precisely measure the temperature of the wafer 200.

Furthermore, by measuring the temperature using the interference of light, temperature information regarding the wafer 200 can be acquired with high accuracy. In addition, the measurement can be performed at a low temperature of, for example, less than -10°C, and thus, the temperature of the wafer 200 can be measured without temperature limitation.

In the method for manufacturing the semiconductor device according to the second embodiment, a temperature change of the wafer 200 is monitored during plasma processing based on the interference light 239sb between the reflected light 238s reflected by the back surface of the wafer 200 and the reflected light 238b reflected by the lower surfaces of the plurality of light shielding layers 210, and the temperature of the wafer 200 is adjusted so that the wafer 200 is maintained at a predetermined temperature.

As a result, the temperature of the wafer 200 can be kept substantially constant during the plasma processing, a variation in etching rate of the workpiece film 110 can be suppressed, and a desired processed shape can be obtained.

In the method for manufacturing the semiconductor device according to the second embodiment, the plurality of light shielding layers 210 are formed on the front surface of the wafer 200 at intervals smaller than a wavelength of the light with which the wafer 200 is irradiated.

As described above, in order to suppress the film peeling of the workpiece film 110, the plurality of light shielding layers 210 are formed at predetermined intervals, for example, rather than covering the entire surface of the wafer 200. In this case as well, by setting the intervals between the plurality of light shielding layers 210 to be smaller than the wavelength of the light, the light is prevented from passing between the plurality of light shielding layers 210. Therefore, it is possible to suppress incidence of light from the wafer 200 into the workpiece film 110 and incidence of light from the workpiece film 110 into the wafer 200.

In the method for manufacturing the semiconductor device according to the second embodiment, a transmittance $T_2$ represented by the above Formula (5), which is a transmittance of light in the plurality of light shielding layers 210, is less than 20%, and more preferably less than 10%. As a result, the influence of light on the side of the workpiece film 110 is sufficiently shielded, and the temperature of the wafer 200 can be precisely measured.

In the second embodiment described above, feedback control is performed so that the temperature of the wafer 200 is maintained constant by changing the gas pressure of the He gas or the like supplied to the electrostatic chuck 220 based on the temperature of the wafer 200 obtained using the interference light. However, the temperature of the wafer 200 may be controlled by another method. For example, the temperature of the wafer 200 can be quickly controlled by using a chiller capable of diverging the refrigerant and controlling the diverged refrigerants to a plurality of set values, such as a dual-type chiller, as the chiller 82 described above, and appropriately switching the refrigerants circulating in the electrostatic chuck to refrigerants having different temperatures.

In the second embodiment described above, the CVD-carbon layer is used as the light shielding layer 210. However, as long as the transmittance $T_2$ represented by the above Formula (5) can be suppressed to less than 20%, another material may be used as the light shielding layer.

Hereinafter, data on some materials that can be candidates will be described.

Figs. 16A and 16B are graphs illustrating optical characteristics of materials that can be candidates for the light shielding layer according to a modification of the second embodiment. Fig. 16A is a graph illustrating a refractive index of each material, with the horizontal axis representing a wavelength of light. Fig. 16B is a graph illustrating an extinction coefficient of each material, with the horizontal axis representing a wavelength of light.

As illustrated in Figs. 16A and 16B, all of titanium, titanium nitride, and tungsten have refractive indexes and extinction coefficients higher than those of carbon, which is a main component of the CVD-carbon layer, with respect to light having a wavelength including a wavelength around (1300±50) nm, which is a measurement wavelength. Regarding tungsten nitride, although there is no data around a wavelength of (1300±50) nm, it is presumed that tungsten nitride has a refractive index and an extinction coefficient higher than those of carbon around a measurement wavelength.

Fig. 17 is a graph illustrating a transmittance of a light shielding layer according to a modification of the second embodiment. Specifically, Fig. 17 illustrates a transmittance $T_2$ of the light shielding layer made of each candidate material obtained from the above Formula (5) in a case where the light shielding layer is formed on the front surface of the wafer using the above candidate material. At this time, similarly to the above-described light shielding layer 210 using the CVD-carbon layer as discussed above, each light shielding layer having a layer thickness of 400 nm is irradiated with light having a wavelength of 1310 nm.

As illustrated in Fig. 17, the transmittance $T_2$ of the light shielding layer using carbon is 7.0247% as described above. In addition, transmittances $T_2$ of light shielding layers using titanium, titanium nitride, tungsten, and tungsten nitride are 0.0009%, $1.89\times10^{-6}$%, $7.18\times10^{-5}$%, and $5.25\times10^{-5}$%, respectively. However, the transmittance $T_2$ of the light shielding layer using tungsten nitride remains as a reference value.

As described above, the light shielding layers using titanium, titanium nitride, tungsten, and tungsten nitride also satisfy the condition of $T_2$<20% for transmittance, and it is considered that the light shielding effect can be sufficiently obtained therefrom.

Examples of materials other than the above materials that satisfy the condition of $T_2$<20% for transmittance include metal-based materials that do not transmit infrared light, such as molybdenum, copper, tungsten silicide, aluminum, gold, and silver.

Also in the light shielding layer using any of the materials as described above, it is preferable to remove the light shielding layers exposed to bottom surfaces of through holes 111 by etching after the through holes 111 are formed. However, in a case where the light shielding layers have conductivity, the light shielding layers do not need to be removed.

[Supplementary Notes]

Hereinafter, supplementary notes for preferred aspects of the present invention will be provided.

(Note 1)

According to a preferred aspect of the present invention, a method for manufacturing a semiconductor device is provided, the method comprising:

preparing a substrate, the substrate including: a workpiece film; and a mask pattern formed on the workpiece film, the mask pattern including a light shielding layer that shields light; and
etching the workpiece film exposed from the mask pattern,
wherein the etching of the workpiece film includes:

irradiating a back surface of the substrate with light in advance;
observing first interference light generated by interference between first reflected light reflected by the back surface of the substrate and second reflected light transmitted through the substrate and reflected by a bottom surface of the workpiece film;
observing second interference light generated by interference between the first reflected light and third reflected light transmitted through the substrate and the workpiece film and reflected without being transmitted through an upper surface of the workpiece film;
calculating a thickness of the workpiece film based on the first interference light and the second interference light; and
performing the etching under an etching condition based on the thickness of the workpiece film calculated from the first interference light and the second interference light.

(Note 2)

In the method for manufacturing a semiconductor device according to Note 1, wherein

the mask pattern contains at least one of carbon, titanium, tungsten, or nitrides thereof as a main component, and
in the etching of the workpiece film, the thickness of the workpiece film is calculated using the third reflected light, the third reflected light being reflected light transmitted through the substrate and the workpiece film and reflected by a bottom surface of the light shielding layer.

(Note 3)

In the method for manufacturing a semiconductor device according to Note 1 or Note 2, wherein the workpiece film is a film in which a plurality of first insulating layers and a plurality of second insulating layers are alternately stacked one by one.

(Note 4)

In the method for manufacturing a semiconductor device according to Note 3, wherein the plurality of first insulating layers included in the workpiece film are 50 or more layers.

(Note 5)

In the method for manufacturing a semiconductor device according to any of Notes 1 to 4, the method further comprising

irradiating the back surface of the substrate with the light before the workpiece film is formed, and observing third interference light generated by interference between fourth reflected light reflected by the back surface of the substrate and fifth reflected light transmitted through the substrate and reflected without being transmitted through a front surface of the substrate,
wherein, in the etching of the workpiece film, the thickness of the workpiece film is calculated based on the third interference light in addition to the first interference light and the second interference light.

(Note 6)

According to another preferred aspect of the present invention, a film thickness measurement method is provided, the method comprising:

preparing a substrate on which a workpiece film is formed;
irradiating a back surface of the substrate with light;
observing first interference light generated by interference between first reflected light reflected by the back surface of the substrate and second reflected light transmitted through the substrate and reflected by a bottom surface of the workpiece film;
observing second interference light generated by interference between the first reflected light and third reflected light transmitted through the substrate and the workpiece film and reflected without being transmitted through an upper surface of the workpiece film; and
calculating a thickness of the workpiece film based on the first interference light and the second interference light.

(Note 7)

In the film thickness measurement method according to Note 6, the method further comprising

forming a pattern in a light shielding layer that shields the light irradiating the substrate,
wherein the thickness of the workpiece film is calculated using the third reflected light, the third reflected light being reflected light transmitted through the substrate and the workpiece film and reflected by a bottom surface of the light shielding layer.

(Note 8)

In the film thickness measurement method according to Note 6 or Note 7, wherein the workpiece film is a film in which a plurality of first insulating layers and a plurality of second insulating layers are alternately stacked one by one.

(Note 9)

In the film thickness measurement method according to Note 8, wherein
the plurality of first insulating layers included in the workpiece film are 50 or more layers.

(Note 10)

In the film thickness measurement method according to any of Notes 6 to 9, the method further comprising

irradiating the back surface of the substrate with the light before the workpiece film is formed, and observing third interference light generated by interference between fourth reflected light reflected by the back surface of the substrate and fifth reflected light transmitted through the substrate and reflected without being transmitted through a front surface of the substrate,
wherein the thickness of the workpiece film is calculated based on the third interference light in addition to the first interference light and the second interference light.

Various embodiments are in accordance with the following numbered clauses.
Clause 1. A method for manufacturing a semiconductor device, the method comprising:
preparing a substrate (200), the substrate (200) including:

a plurality of light shielding layers (210) arranged at predetermined intervals to shield light having a predetermined wavelength;
a workpiece film (110) located on the plurality of light shielding layers (210), and including a plurality of first insulating layers (NL) and a plurality of second insulating layers (OL) alternately stacked one by one; and
a mask pattern (120p) located on the workpiece film (110) and having a plurality of openings; and
etching the workpiece film (110) exposed from the plurality of openings,
wherein the etching of the workpiece film (110) includes:

irradiating a back surface of the substrate (200) with the light while etching the workpiece film (110);
observing interference light (239sb) generated by interference between first reflected light (238s) reflected by the back surface of the substrate (200) and second reflected light (238b) transmitted through the substrate (200) and reflected by bottom surfaces of the plurality of light shielding layers (238b);
calculating a temperature of the substrate (200) during etching processing based on the interference light (239sb); and
adjusting the temperature of the substrate (200) during the etching processing based on the temperature of the substrate (200) calculated from the interference light (239sb).

Clause 2. The method for manufacturing a semiconductor device according to Clause 1, wherein
in the etching of the workpiece film (110), a temperature change of the substrate (200) is monitored during the etching processing based on the interference light (239sb), and the temperature of the substrate (200) is adjusted so that the substrate (200) is maintained at a predetermined temperature.
Clause 3. The method for manufacturing a semiconductor device according to Clause 1 or 2, wherein
the plurality of light shielding layers (210) are formed on a front surface of the substrate (200) at intervals each of which is smaller than the wavelength of the light irradiating the substrate (200).
Clause 4. The method for manufacturing a semiconductor device according to any of Clauses 1 to 3, wherein

a transmittance T of the light in the plurality of light shielding layers (210) is represented by the following formula:

$$T = \left\{1 - \left(\frac{n_1 - n_0}{n_1 + n_0}\right)^2\right\}\left\{1 - \left(\frac{n_2 - n_1}{n_2 + n_1}\right)^2\right\} e^{-\frac{4\pi k d}{\lambda}}$$

A: *WA VELENGTH*

*d : LAYER THICKNESS OF LIGHT SHIELDING LAYER*

$n_i$ : *REFRACTIVE INDEX OF LIGHT SHIELDING LAYER OR*

*LAYER LOCATED ON OR UNDER LIGHT SHIELDING LAYER*

*k : EXTINCTION COEFFICIENT OF LIGHT SHIELDING LAYER*

and
the transmittance T is less than 20%.

Clause 5. The method for manufacturing a semiconductor device according to any of Clauses 1 to 4, wherein the plurality of light shielding layers (210) contain at least one of carbon, titanium, tungsten, and nitrides thereof as a main component.

Clause 6. A temperature measurement method comprising:

preparing a substrate (200), with a plurality of light shielding layers (210) that shields light having a predetermined wavelength being formed on a front surface of the substrate (200) at predetermined intervals, a workpiece film (110) being formed by alternately stacking a plurality of first insulating layers (NL) and a plurality of second insulating layers (OL) one by one on the plurality of light shielding layers (210), and a mask pattern (120p) being formed on the workpiece film (110) and having a plurality of openings;
irradiating a back surface of the substrate (200) with the light while etching the workpiece film (110) exposed from the plurality of openings;
observing interference light (239sb) generated by interference between first reflected light (238s) reflected by the back surface of the substrate (200) and second reflected light (238b) transmitted through the substrate (200) and reflected by bottom surfaces of the plurality of light shielding layers (210); and
calculating a temperature of the substrate (200) during etching processing based on the interference light (239sb).

Clause 7. The temperature measurement method according to Clause 6, wherein
while the measurement of the temperature of the substrate (200) is performed, a temperature change of the substrate (200) is monitored during the etching processing based on the interference light (239sb), and the substrate (200) is maintained at a predetermined temperature.

Clause 8. The temperature measurement method according to Clause 6 or 7, wherein
the plurality of light shielding layers (210) are formed on the front surface of the substrate (200) at intervals each of which is smaller than the wavelength of the light irradiating the substrate (200).

Clause 9. The temperature measurement method according to any of Clauses 6 to 8, wherein

a transmittance T of the light in the plurality of light shielding layers (210) is represented by the following formula:

$$T = \left\{1 - \left(\frac{n_1 - n_0}{n_1 + n_0}\right)^2\right\}\left\{1 - \left(\frac{n_2 - n_1}{n_2 + n_1}\right)^2\right\} e^{-\frac{4\pi k d}{\lambda}}$$

A : *WA VELENGTH*

*d* : *LAYER THICKNESS OF LIGHT SHIELDING LAYER*

$n_i$ : *REFRACTIVE INDEX OF LIGHT SHIELDING LAYER OR*

*LAYER LOCATED ON OR UNDER LIGHT SHIELDING LAYER*

*k : EXTINCTION COEFFICIENT OF LIGHT SHIELDING LAYER*

and
the transmittance T is less than 20%.

Clause 10. The temperature measurement method according to Clause 9, wherein
the plurality of light shielding layers (210) contain at least one of carbon, titanium, tungsten, or nitrides thereof as a main component.

Clause 11. A temperature measurement substrate comprising:

a substrate (200) having a front surface on which a plurality of light shielding layers (210) that shields light having a predetermined wavelength is arranged at predetermined intervals; and
a workpiece film (110) disposed above the substrate (200) and formed by alternately stacking a plurality of first insulating layers (NL) and a plurality of second insulating layers (OL) one by one.

Clause 12. The temperature measurement substrate according to Clause 11, further comprising
a mask pattern (120p) disposed on the workpiece film (110) and having a plurality of openings.
Clause 13. The temperature measurement substrate according to Clause 11 or 12, wherein
the plurality of light shielding layers (210) contain at least one of carbon, titanium, tungsten, and nitrides thereof as a main component.
While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A method for manufacturing a semiconductor device, the method comprising:
preparing a substrate (200), the substrate (200) including:

    a plurality of light shielding layers (210) arranged at predetermined intervals to shield light having a predetermined wavelength;
    a workpiece film (110) located on the plurality of light shielding layers (210), and including a plurality of first insulating layers (NL) and a plurality of second insulating layers (OL) alternately stacked one by one; and
    a mask pattern (120p) located on the workpiece film (110) and having a plurality of openings; and
    etching the workpiece film (110) exposed from the plurality of openings,
    wherein the etching of the workpiece film (110) includes:

        irradiating a back surface of the substrate (200) with the light while etching the workpiece film (110);
        observing interference light (239sb) generated by interference between first reflected light (238s) reflected by the back surface of the substrate (200) and second reflected light (238b) transmitted through the substrate (200) and reflected by bottom surfaces of the plurality of light shielding layers (238b);
        calculating a temperature of the substrate (200) during etching processing based on the interference light (239sb); and
        adjusting the temperature of the substrate (200) during the etching processing based on the temperature of the substrate (200) calculated from the interference light (239sb).

2. The method for manufacturing a semiconductor device according to claim 1, wherein
in the etching of the workpiece film (110), a temperature change of the substrate (200) is monitored during the etching processing based on the interference light (239sb), and the temperature of the substrate (200) is adjusted so that the substrate (200) is maintained at a predetermined temperature.

3. The method for manufacturing a semiconductor device according to claim 1 or 2, wherein
the plurality of light shielding layers (210) are formed on a front surface of the substrate (200) at intervals each of which is smaller than the wavelength of the light irradiating the substrate (200).

4. The method for manufacturing a semiconductor device according to any preceding claim, wherein

    a transmittance T of the light in the plurality of light shielding layers (210) is represented by the following formula:

$$T = \left\{1 - \left(\frac{n_1 - n_0}{n_1 + n_0}\right)^2\right\}\left\{1 - \left(\frac{n_2 - n_1}{n_2 + n_1}\right)^2\right\} e^{-\frac{4\pi k d}{\lambda}}$$

A : *WA VELENGTH*
$d$ : *LAYER THICKNESS OF LIGHT SHIELDING LAYER*
$n_i$ : *REFRACTIVE INDEX OF LIGHT SHIELDING LAYER OR LAYER LOCATED ON OR UNDER LIGHT SHIELDING LAYER*
$k$ : *EXTINCTION COEFFICIENT OF LIGHT SHIELDING LAYER*

and
the transmittance T is less than 20%.

**5.** The method for manufacturing a semiconductor device according to any preceding claim, wherein the plurality of light shielding layers (210) contain at least one of carbon, titanium, tungsten, and nitrides thereof as a main component.

**6.** A temperature measurement method comprising:

preparing a substrate (200), with a plurality of light shielding layers (210) that shields light having a predetermined wavelength being formed on a front surface of the substrate (200) at predetermined intervals, a workpiece film (110) being formed by alternately stacking a plurality of first insulating layers (NL) and a plurality of second insulating layers (OL) one by one on the plurality of light shielding layers (210), and a mask pattern (120p) being formed on the workpiece film (110) and having a plurality of openings;
irradiating a back surface of the substrate (200) with the light while etching the workpiece film (110) exposed from the plurality of openings;
observing interference light (239sb) generated by interference between first reflected light (238s) reflected by the back surface of the substrate (200) and second reflected light (238b) transmitted through the substrate (200) and reflected by bottom surfaces of the plurality of light shielding layers (210); and
calculating a temperature of the substrate (200) during etching processing based on the interference light (239sb).

**7.** The temperature measurement method according to claim 6, wherein while the measurement of the temperature of the substrate (200) is performed, a temperature change of the substrate (200) is monitored during the etching processing based on the interference light (239sb), and the substrate (200) is maintained at a predetermined temperature.

**8.** The temperature measurement method according to claim 6 or 7, wherein the plurality of light shielding layers (210) are formed on the front surface of the substrate (200) at intervals each of which is smaller than the wavelength of the light irradiating the substrate (200).

**9.** The temperature measurement method according to any of claims 6 to 8, wherein

a transmittance T of the light in the plurality of light shielding layers (210) is represented by the following formula:

$$T = \left\{1 - \left(\frac{n_1 - n_0}{n_1 + n_0}\right)^2\right\}\left\{1 - \left(\frac{n_2 - n_1}{n_2 + n_1}\right)^2\right\} e^{-\frac{4\pi k d}{\lambda}}$$

$\lambda$ : *WAVELENGTH*
$d$ : *LAYER THICKNESS OF LIGHT SHIELDING LAYER*
$n_i$ : *REFRACTIVE INDEX OF LIGHT SHIELDING LAYER OR LAYER LOCATED ON OR UNDER LIGHT SHIELDING LAYER*
$k$ : *EXTINCTION COEFFICIENT OF LIGHT SHIELDING LAYER*

and
the transmittance T is less than 20%.

**10.** The temperature measurement method according to claim 9, wherein the plurality of light shielding layers (210) contain at least one of carbon, titanium, tungsten, or nitrides thereof as a main component.

**11.** A temperature measurement substrate comprising:

a substrate (200) having a front surface on which a plurality of light shielding layers (210) that shields light having a predetermined wavelength is arranged at predetermined intervals; and
a workpiece film (110) disposed above the substrate (200) and formed by alternately stacking a plurality of first insulating layers (NL) and a plurality of second insulating layers (OL) one by one.

**12.** The temperature measurement substrate according to claim 11, further comprising
a mask pattern (120p) disposed on the workpiece film (110) and having a plurality of openings.

**13.** The temperature measurement substrate according to claim 11 or 12, wherein
the plurality of light shielding layers (210) contain at least one of carbon, titanium, tungsten, and nitrides thereof as a main component.

FIG.1

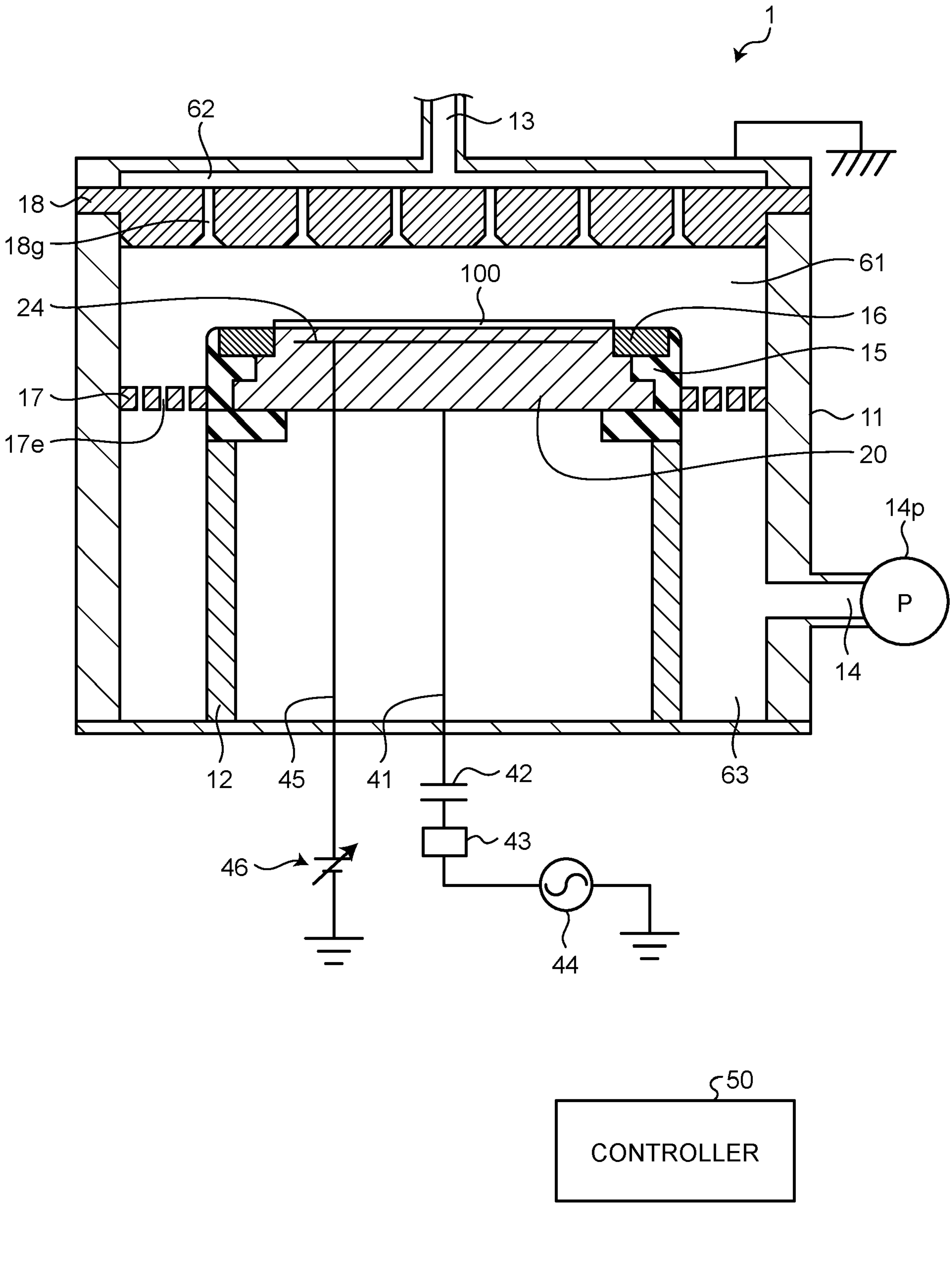
1
62
13
18
18g
61
100
24
16
15
17
11
17e
20
14p
P
14
12
45
41
42
63
43
46
44
50
CONTROLLER

FIG.2

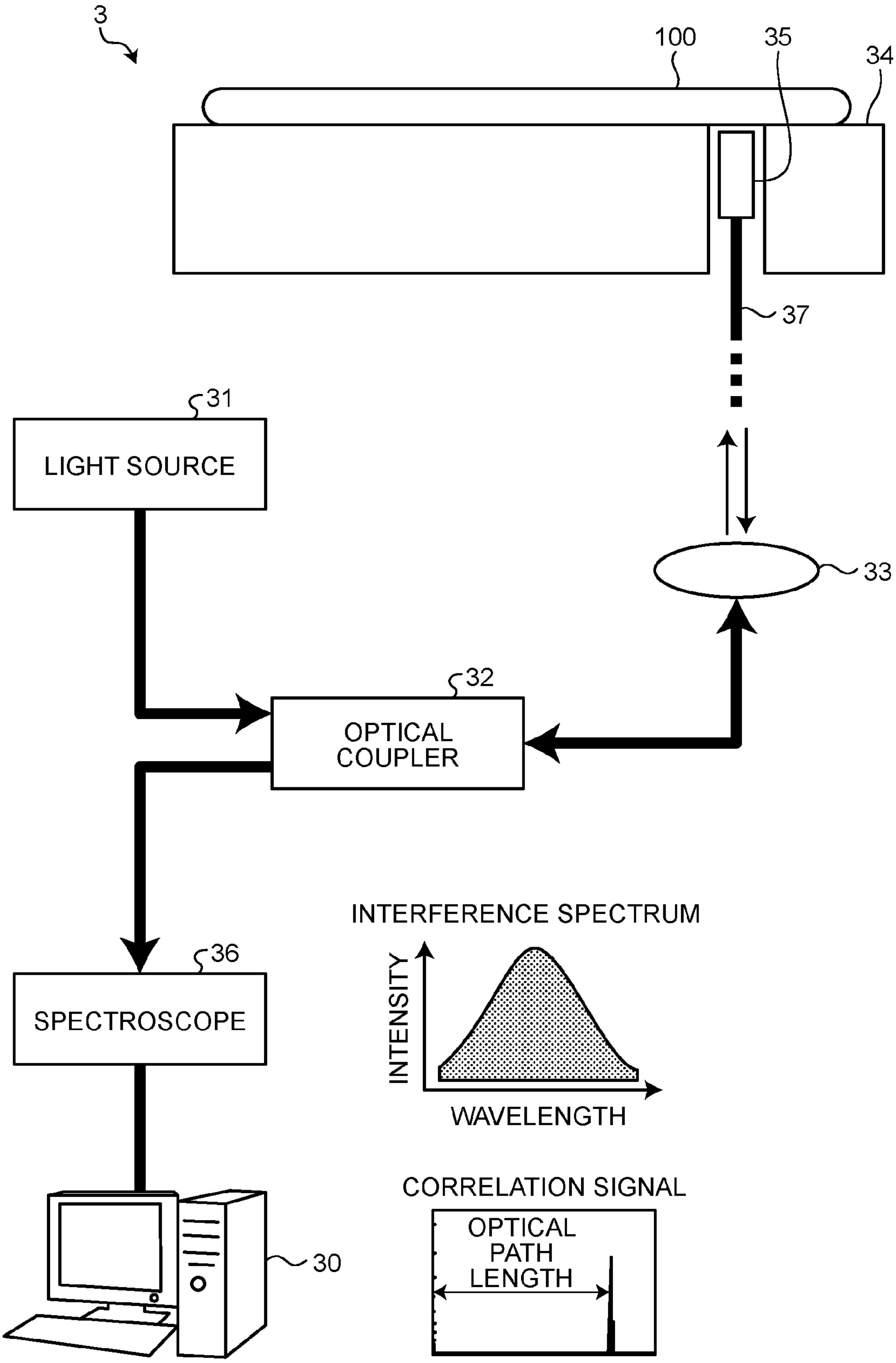
3
100
35
34
37
31
LIGHT SOURCE
33
32
OPTICAL COUPLER
INTERFERENCE SPECTRUM
INTENSITY
WAVELENGTH
36
SPECTROSCOPE
CORRELATION SIGNAL
OPTICAL PATH LENGTH
30

FIG.3A

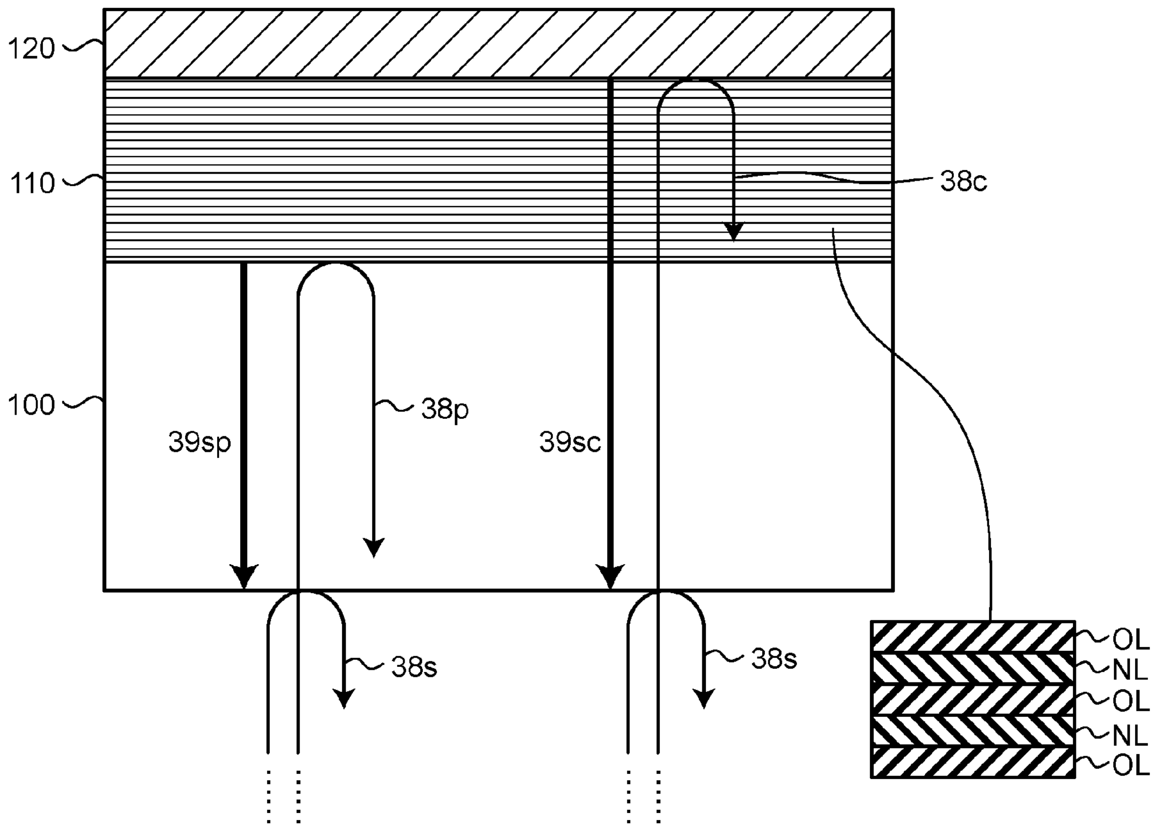
120
110
100
38c
39sp
38p
39sc
38s
38s
OL
NL
OL
NL
OL

FIG.3B

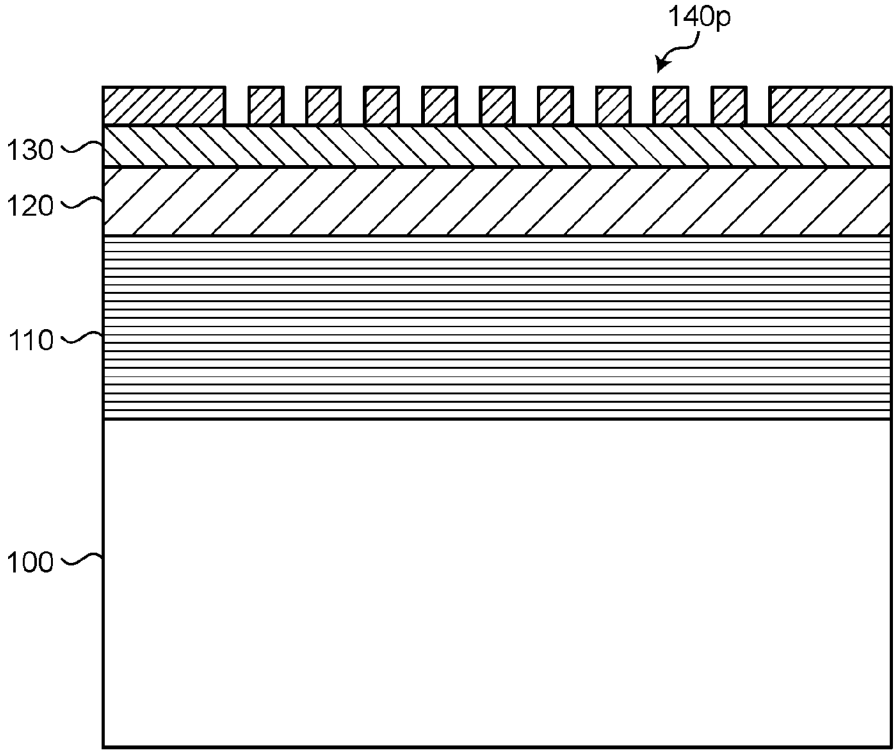
140p
130
120
110
100

FIG.4A

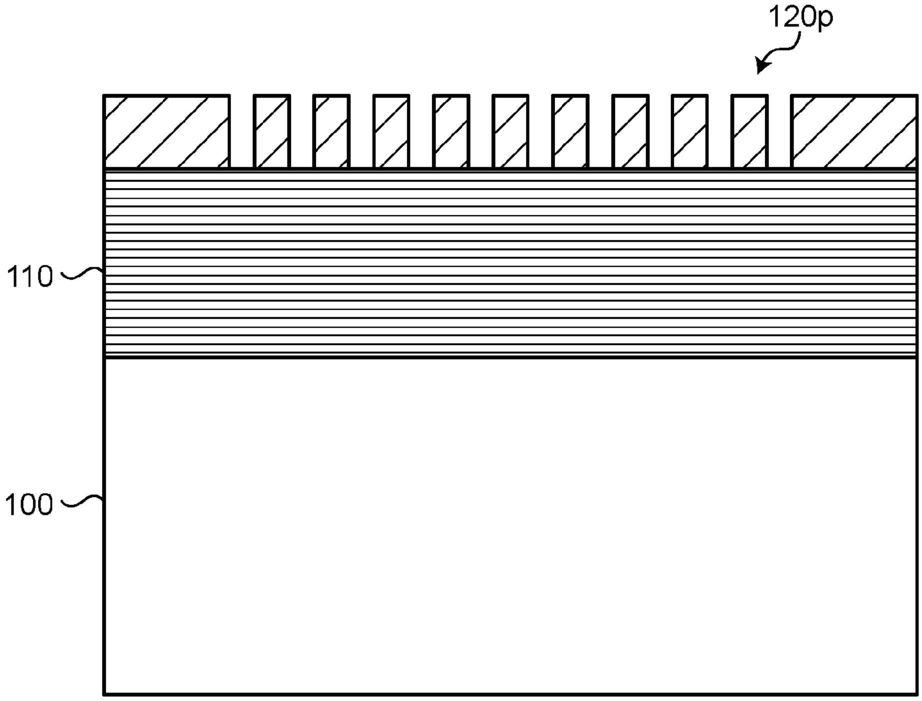


FIG.4B

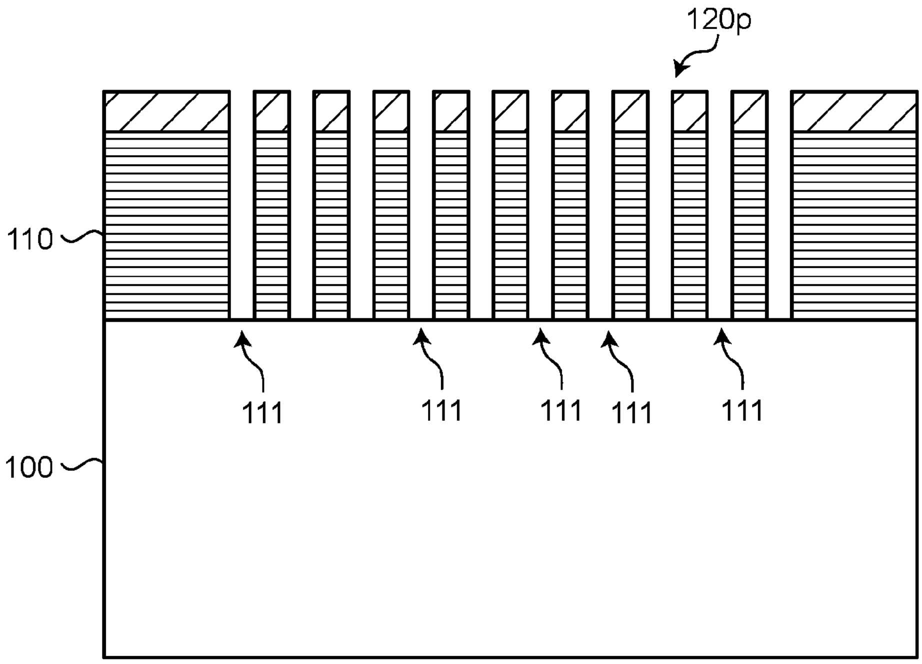

FIG.5A

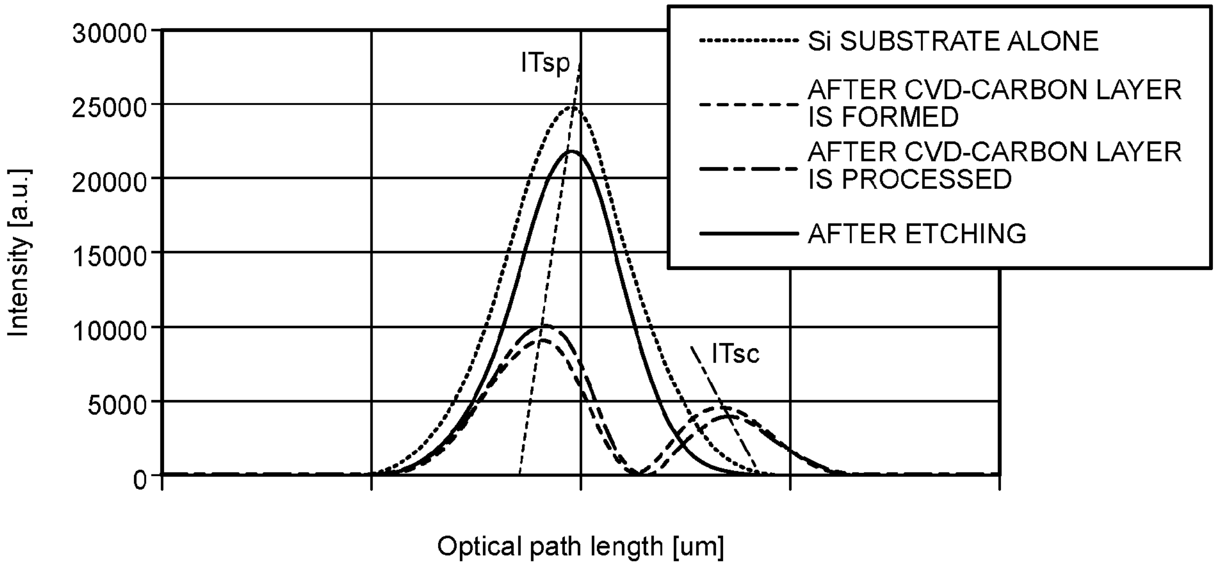


FIG.5B

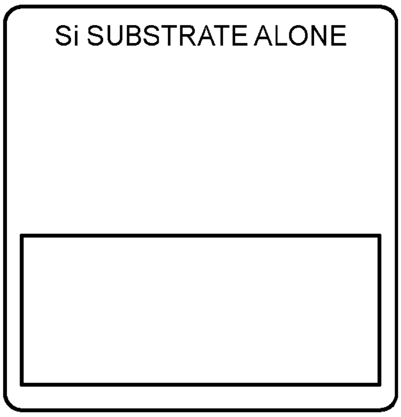


FIG.5C

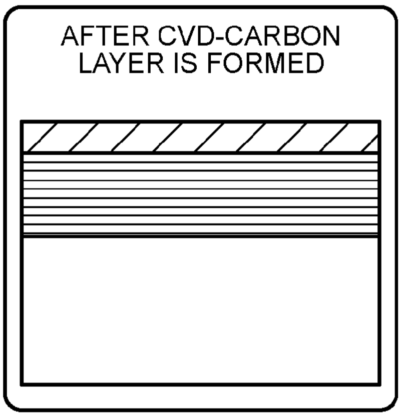


FIG.5D

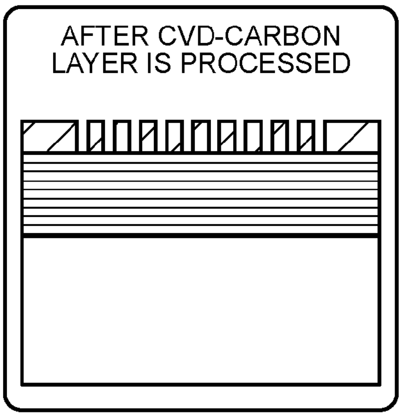


FIG.5E

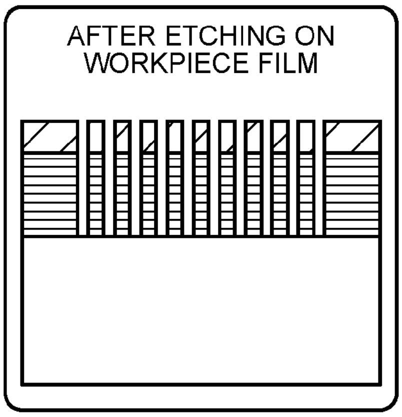

FIG.6

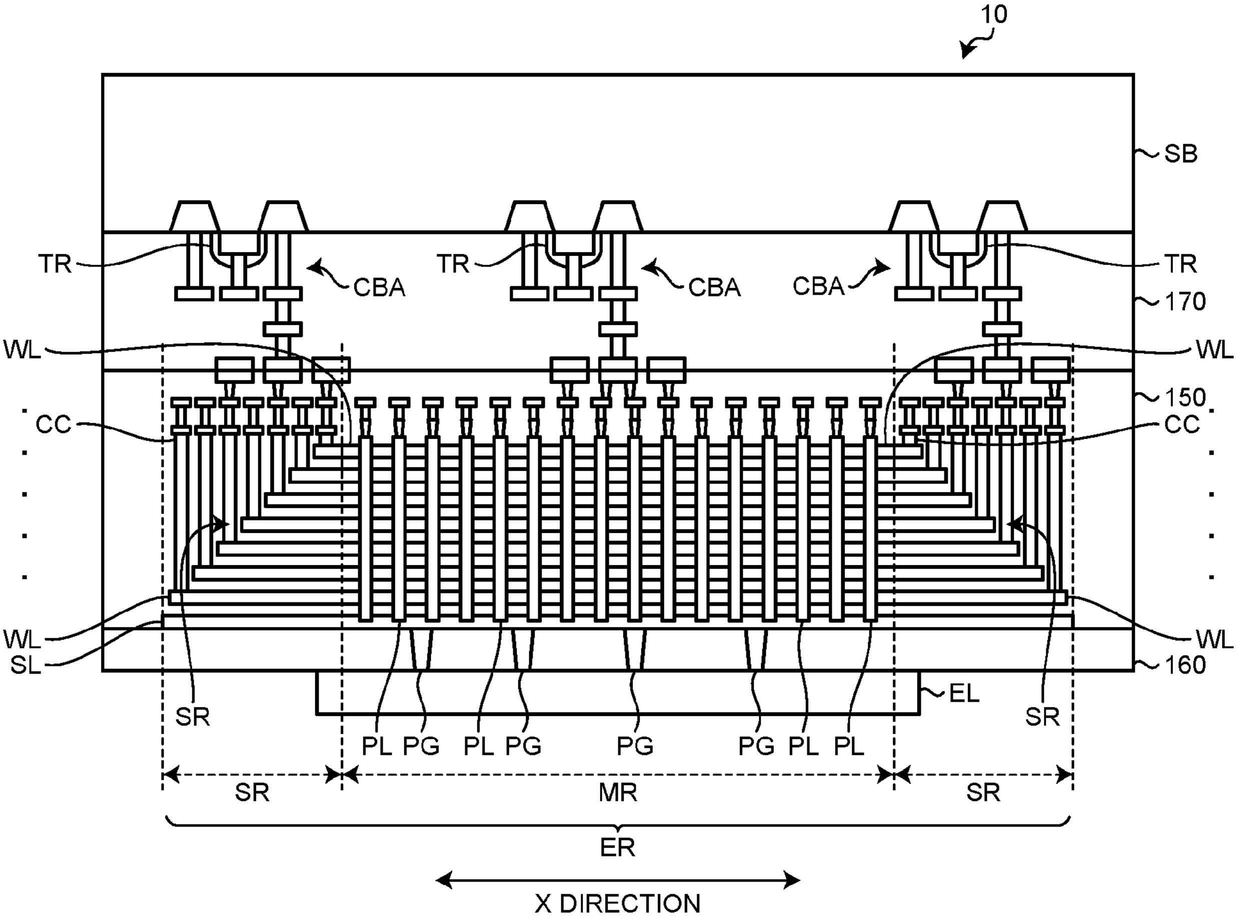
10
SB
TR
CBA
TR
CBA
CBA
TR
170
WL
WL
150
CC
CC
WL
SL
WL
160
EL
SR
SR
PL PG PL PG PG PG PL PL
SR
MR
SR
ER
X DIRECTION

FIG.7

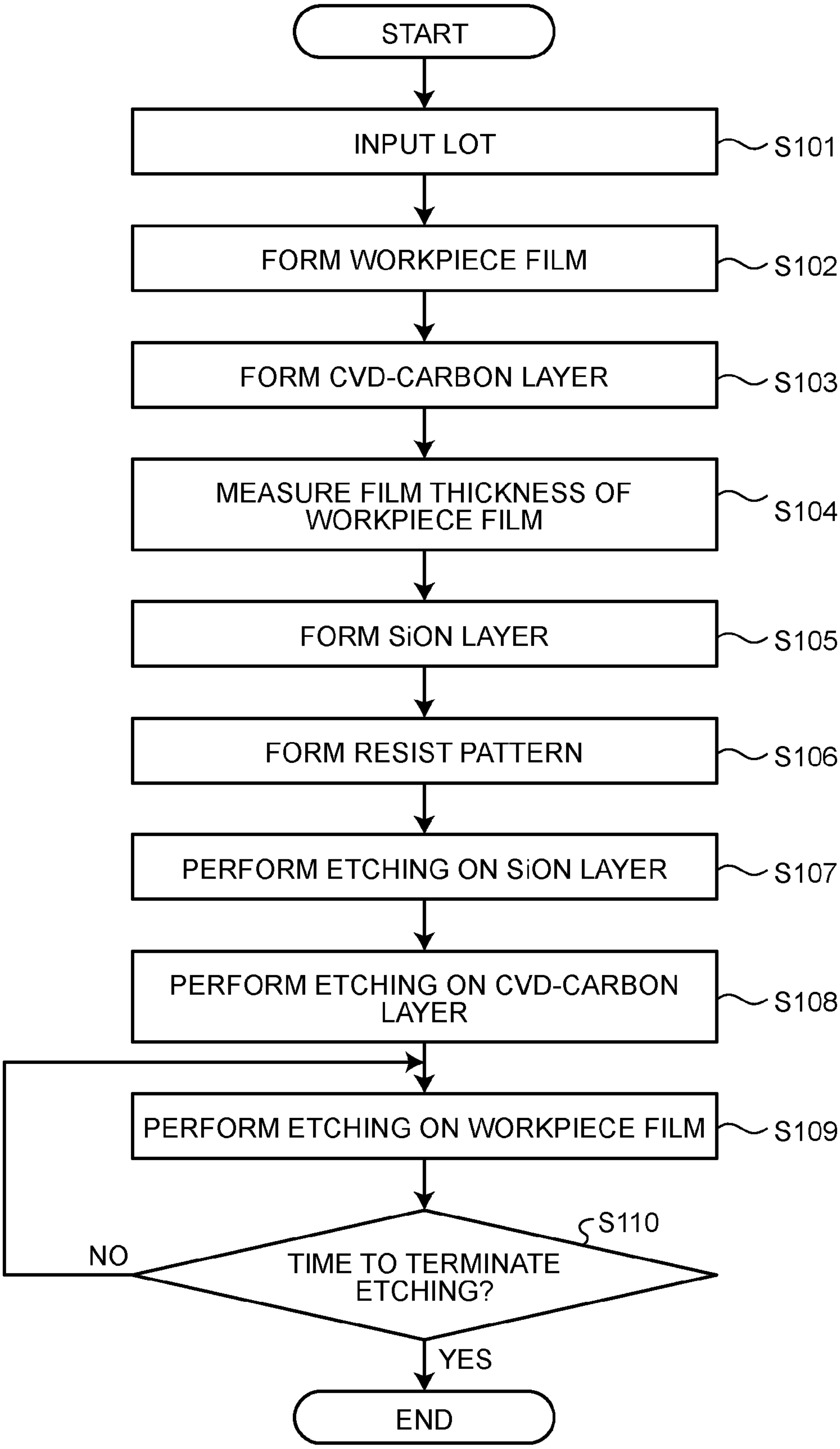
START
INPUT LOT
S101
FORM WORKPIECE FILM
S102
FORM CVD-CARBON LAYER
S103
MEASURE FILM THICKNESS OF WORKPIECE FILM
S104
FORM SiON LAYER
S105
FORM RESIST PATTERN
S106
PERFORM ETCHING ON SiON LAYER
S107
PERFORM ETCHING ON CVD-CARBON LAYER
S108
PERFORM ETCHING ON WORKPIECE FILM
S109
S110
TIME TO TERMINATE ETCHING?
NO
YES
END

# FIG.8

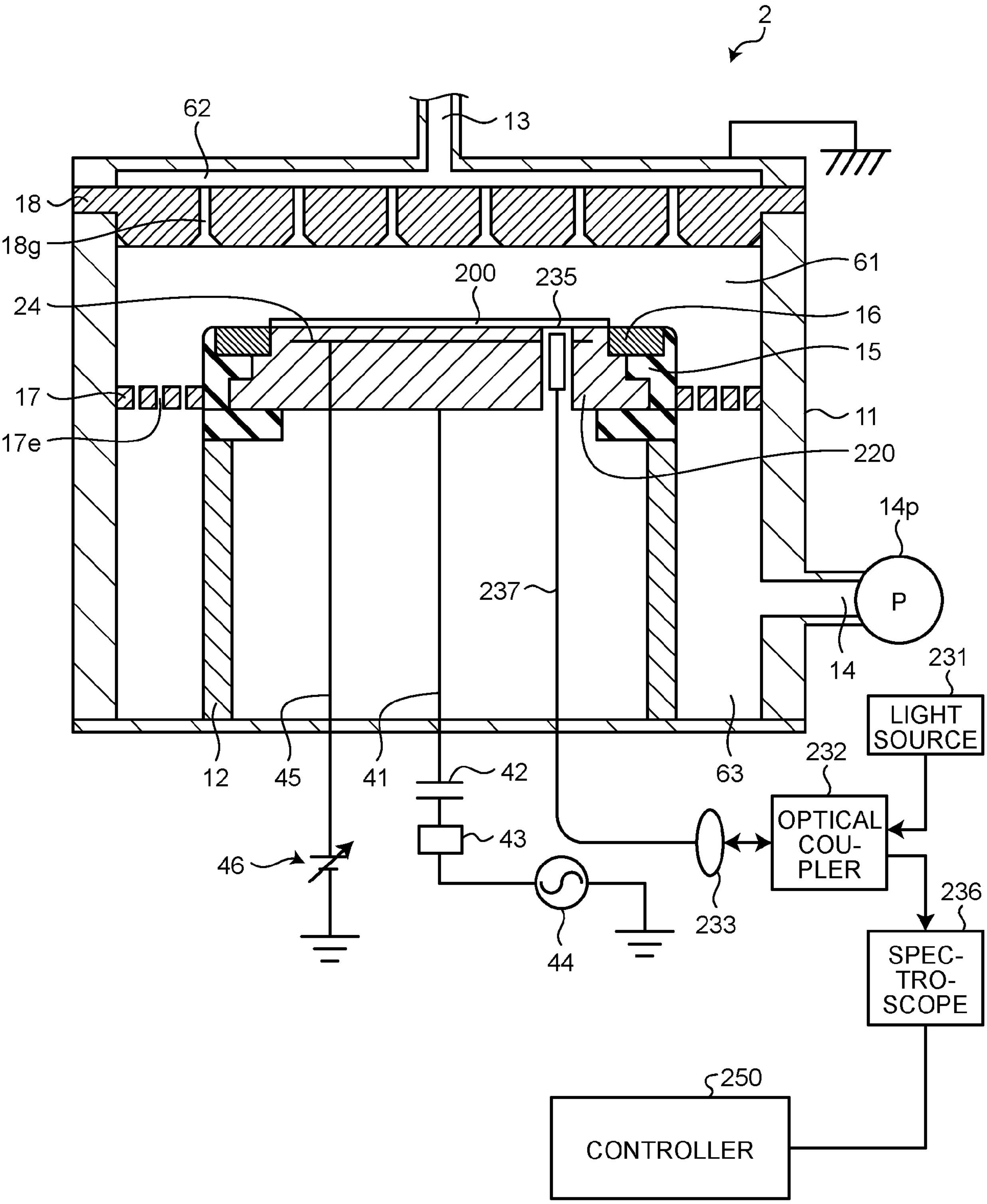
2
62
13
18
18g
61
200
235
24
16
15
17
17e
11
220
14p
P
237
14
231
LIGHT SOURCE
12
45
41
42
63
232
OPTICAL COU- PLER
43
46
233
44
236
SPEC- TRO- SCOPE
250
CONTROLLER

FIG.9A

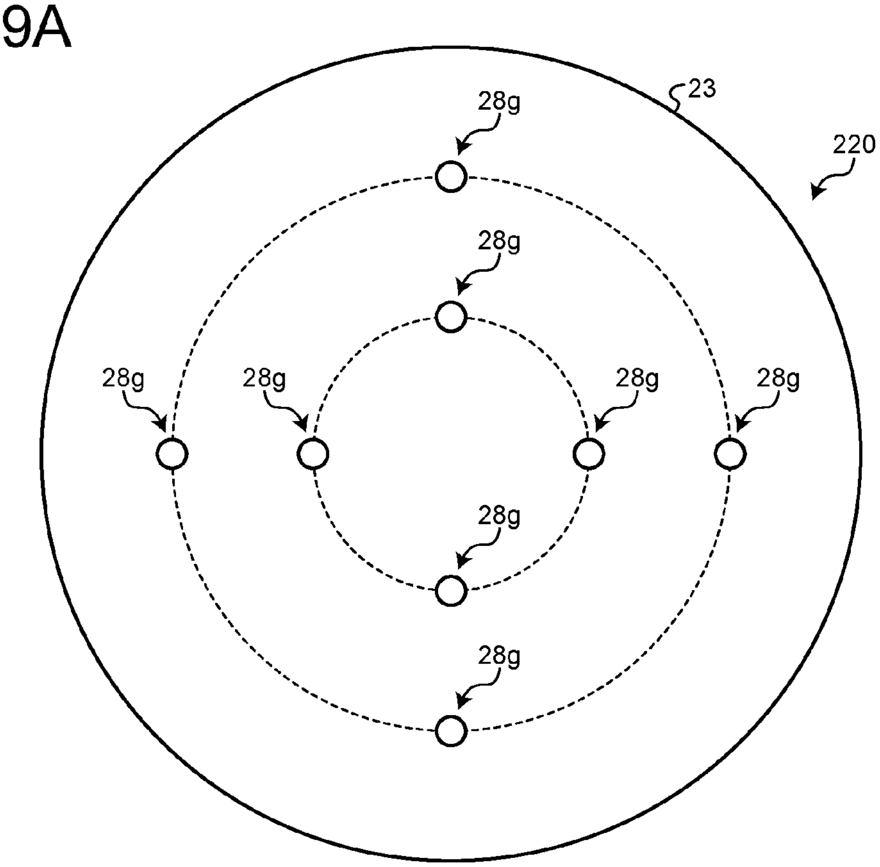
28g
23
220
28g
28g
28g
28g
28g
28g
28g

FIG.9B

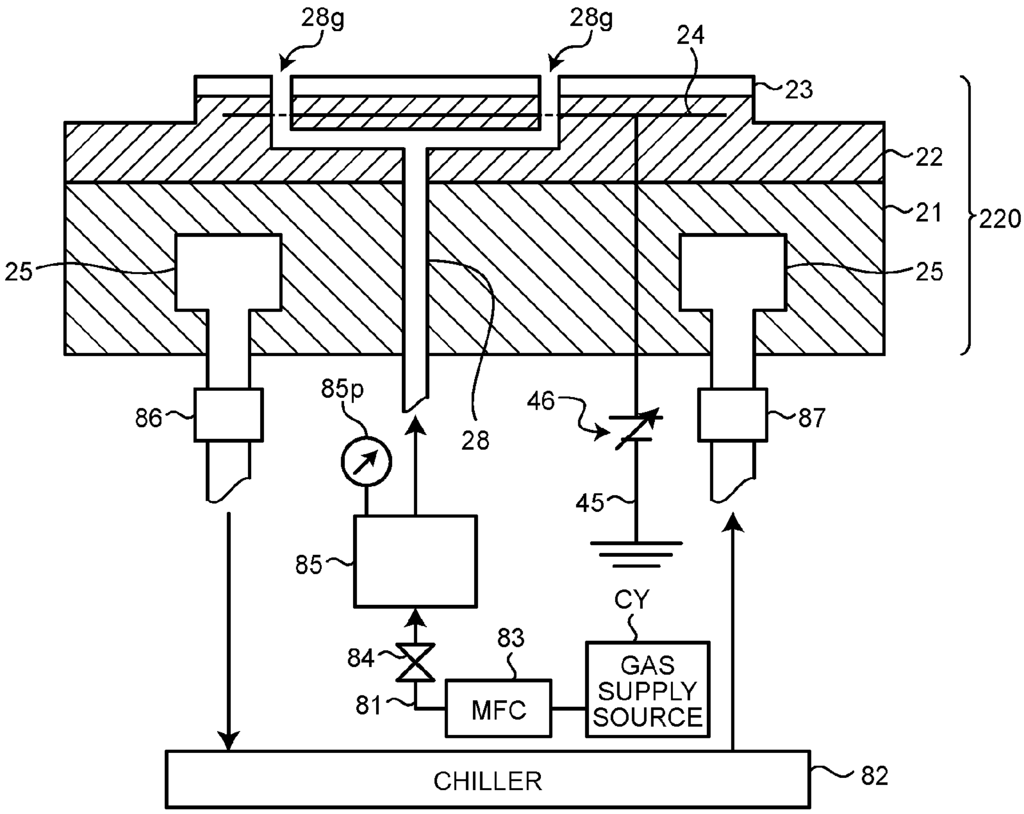
28g
28g
24
23
22
21
220
25
25
86
85p
28
46
87
45
85
CY
84
83
GAS
SUPPLY
SOURCE
81
MFC
CHILLER
82

FIG.10A

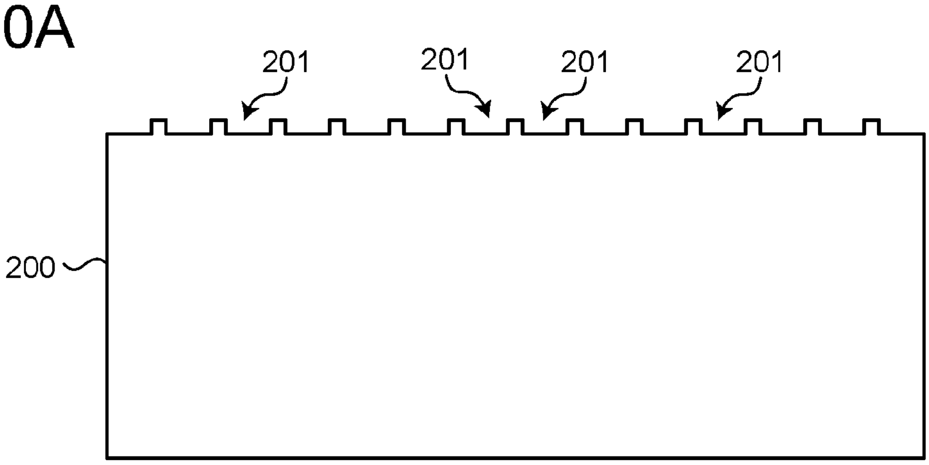


FIG.10B

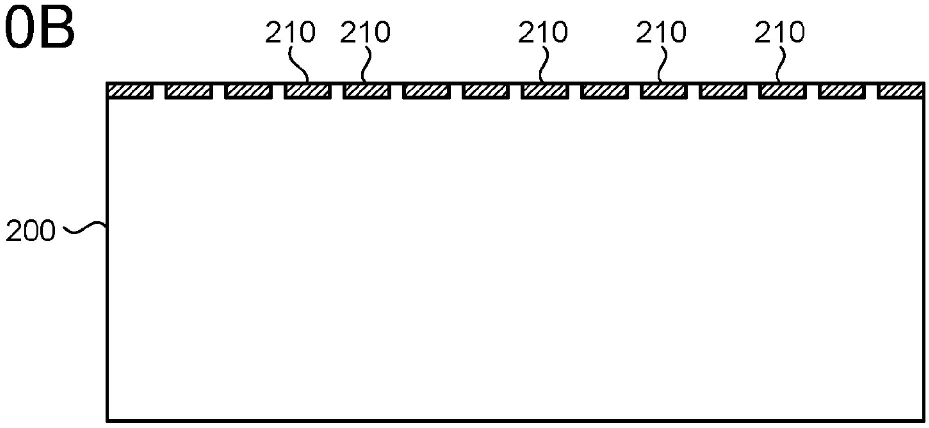


FIG.10C

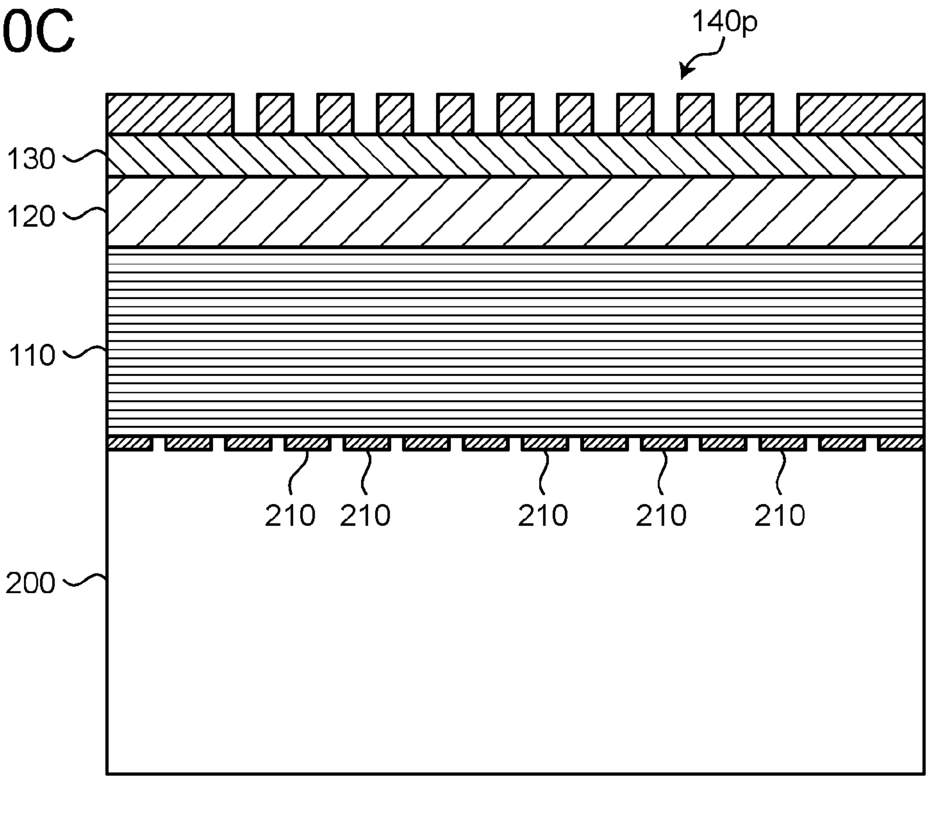

FIG.11A

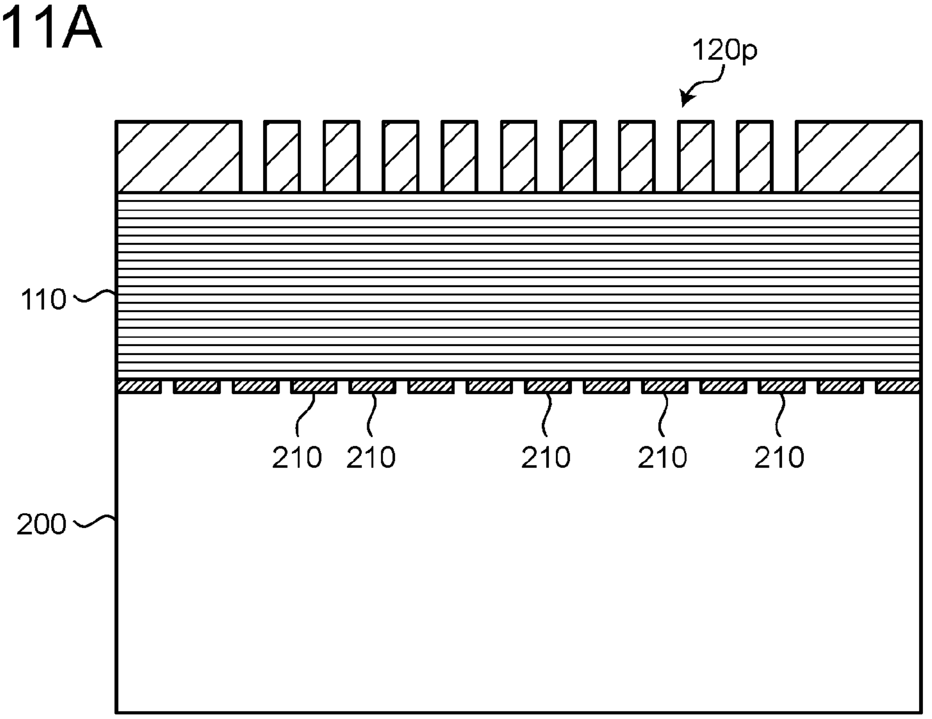


FIG.11B

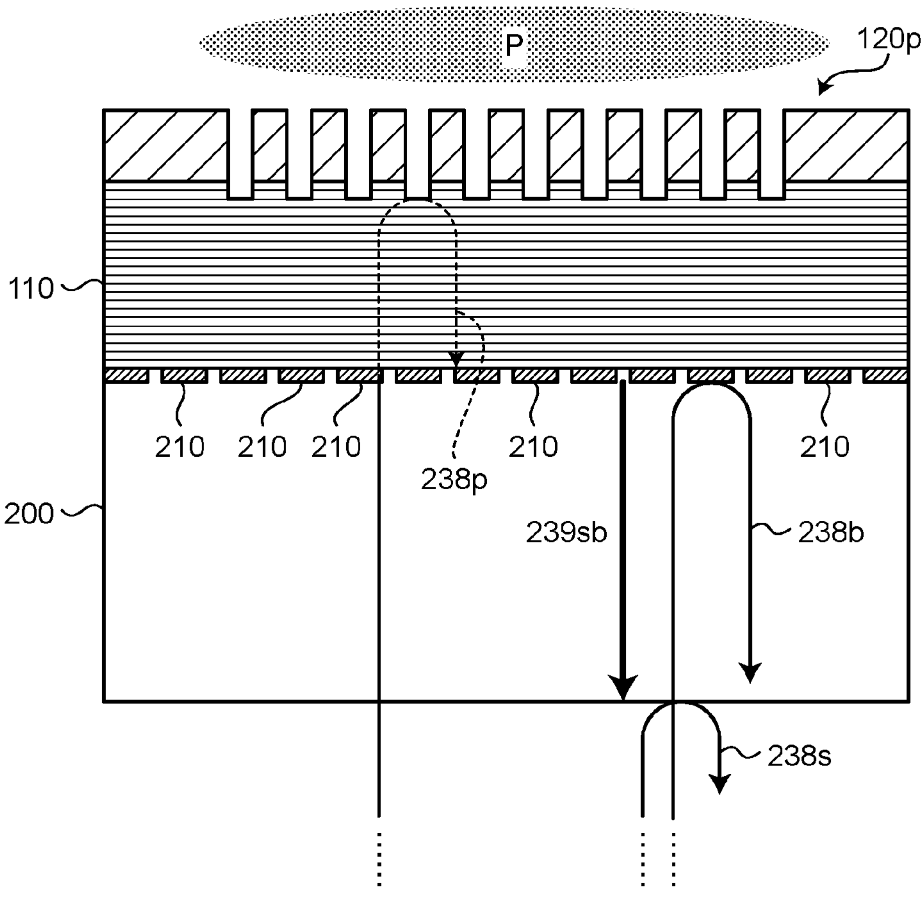

FIG.12A

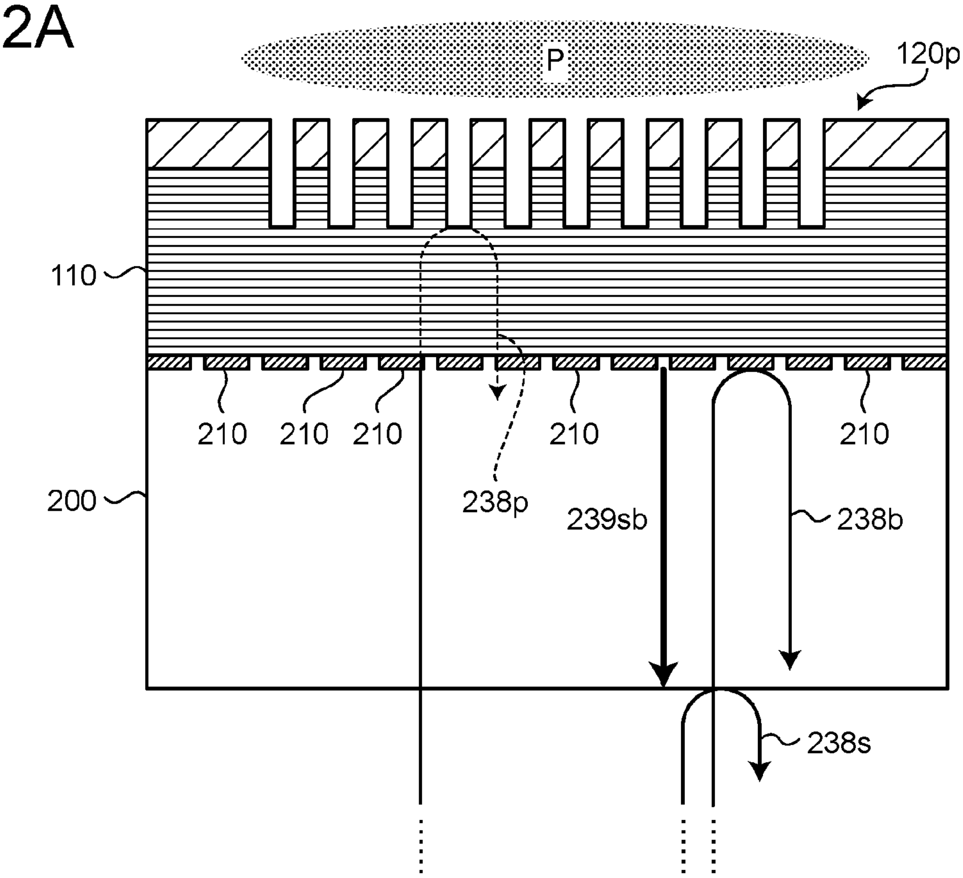


FIG.12B

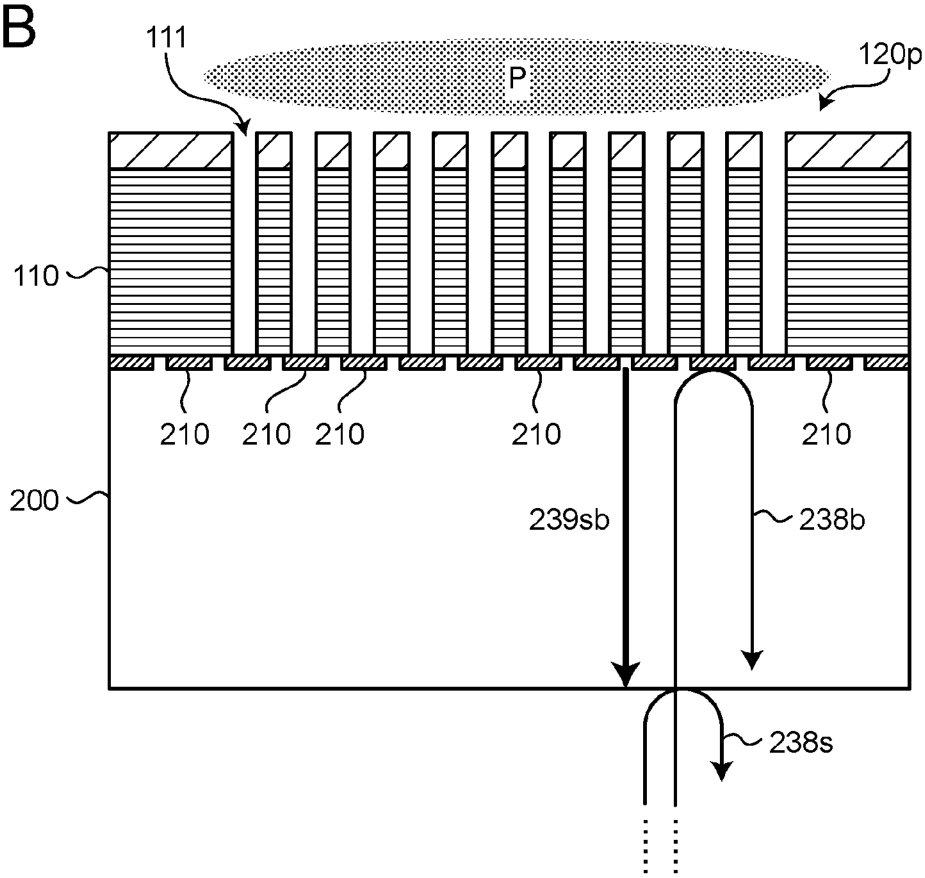

FIG.13

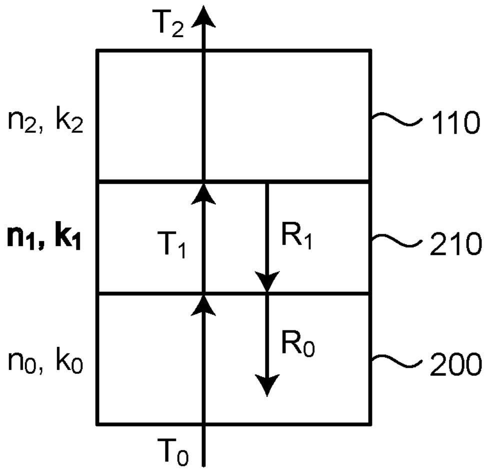


FIG.14A

FIG.14B

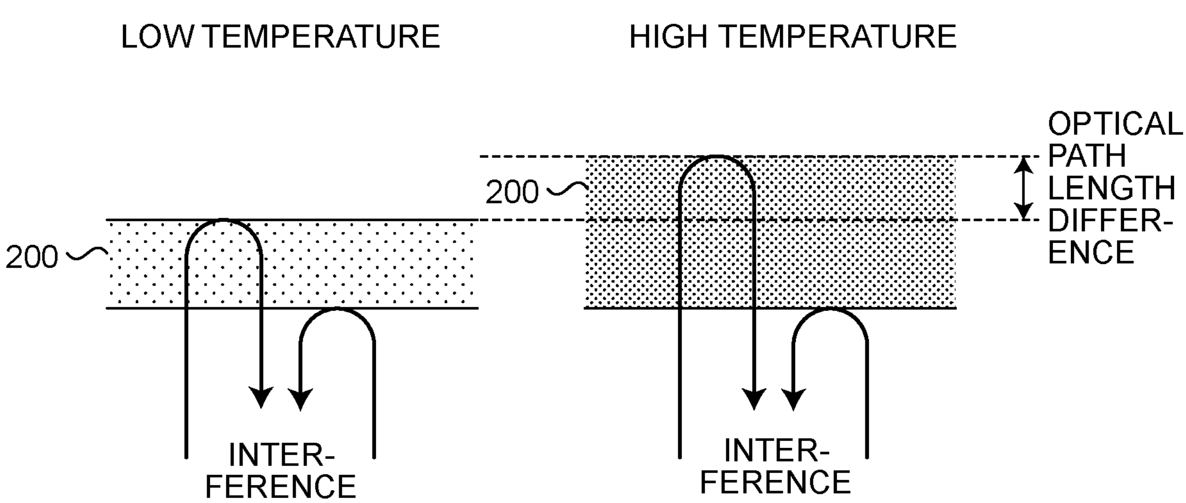

FIG.15

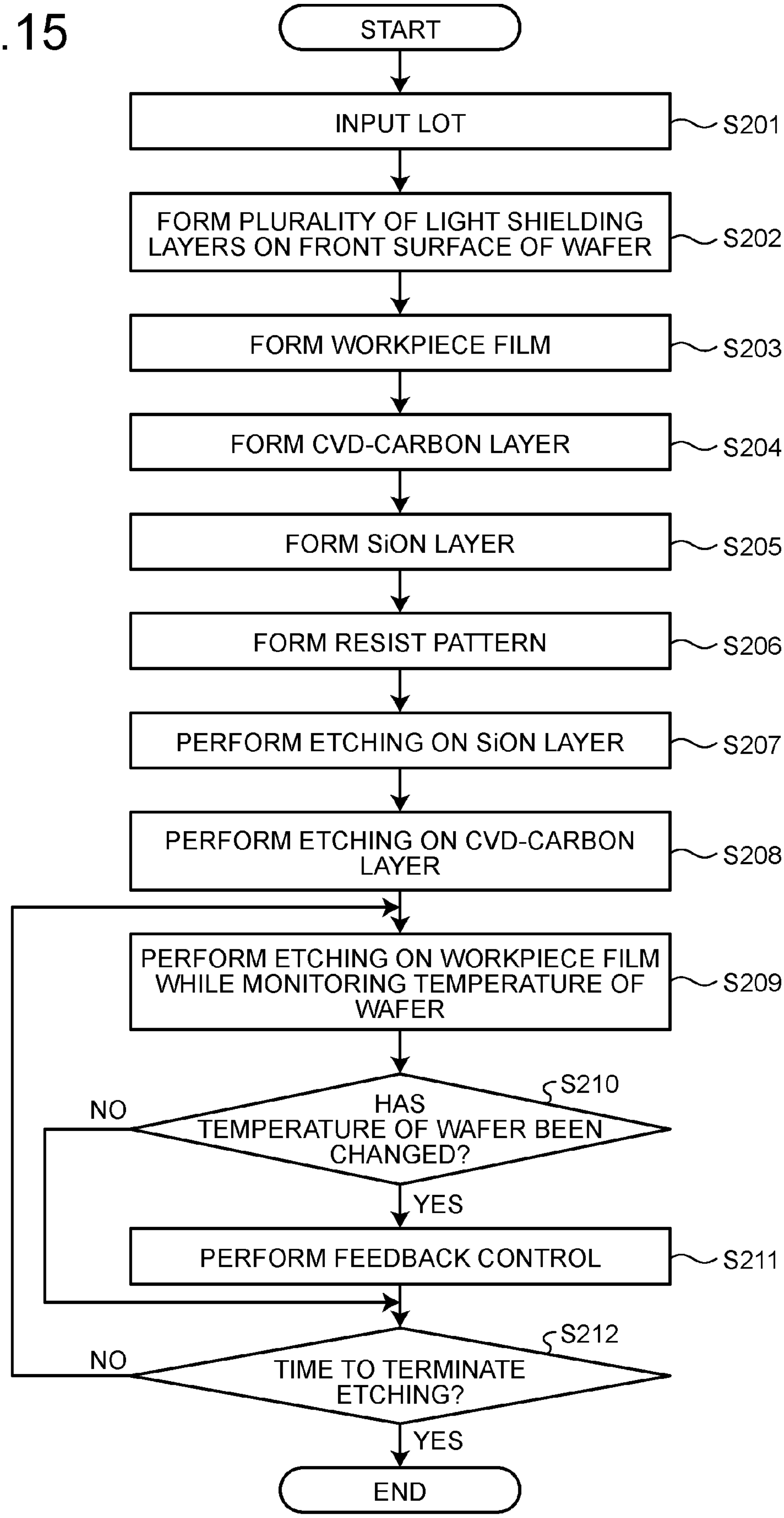
START
INPUT LOT
S201
FORM PLURALITY OF LIGHT SHIELDING LAYERS ON FRONT SURFACE OF WAFER
S202
FORM WORKPIECE FILM
S203
FORM CVD-CARBON LAYER
S204
FORM SiON LAYER
S205
FORM RESIST PATTERN
S206
PERFORM ETCHING ON SiON LAYER
S207
PERFORM ETCHING ON CVD-CARBON LAYER
S208
PERFORM ETCHING ON WORKPIECE FILM WHILE MONITORING TEMPERATURE OF WAFER
S209
HAS TEMPERATURE OF WAFER BEEN CHANGED?
S210
NO
YES
PERFORM FEEDBACK CONTROL
S211
TIME TO TERMINATE ETCHING?
S212
NO
YES
END

# FIG.16A

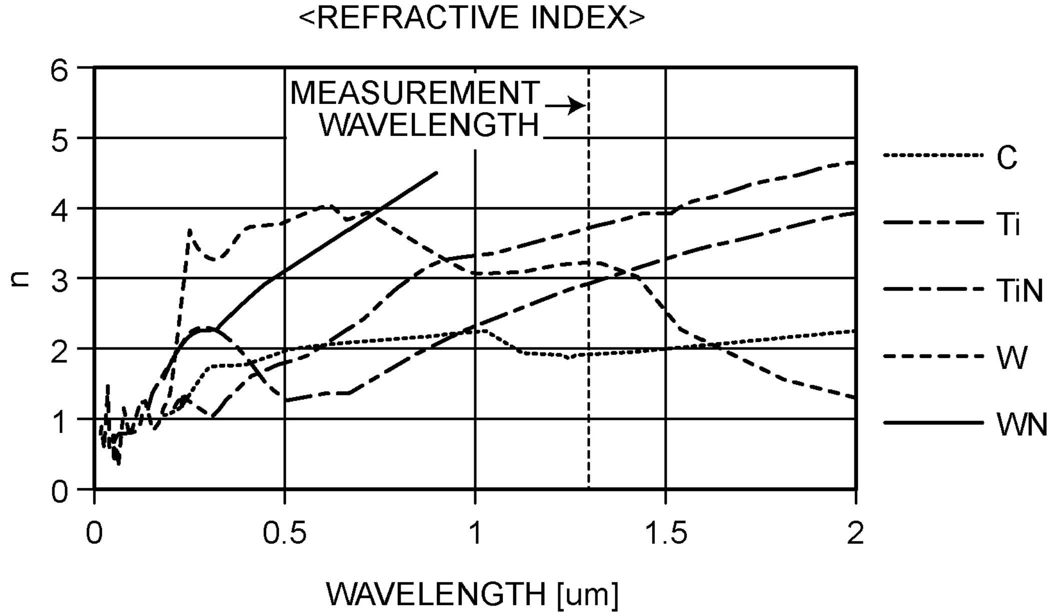


# FIG.16B

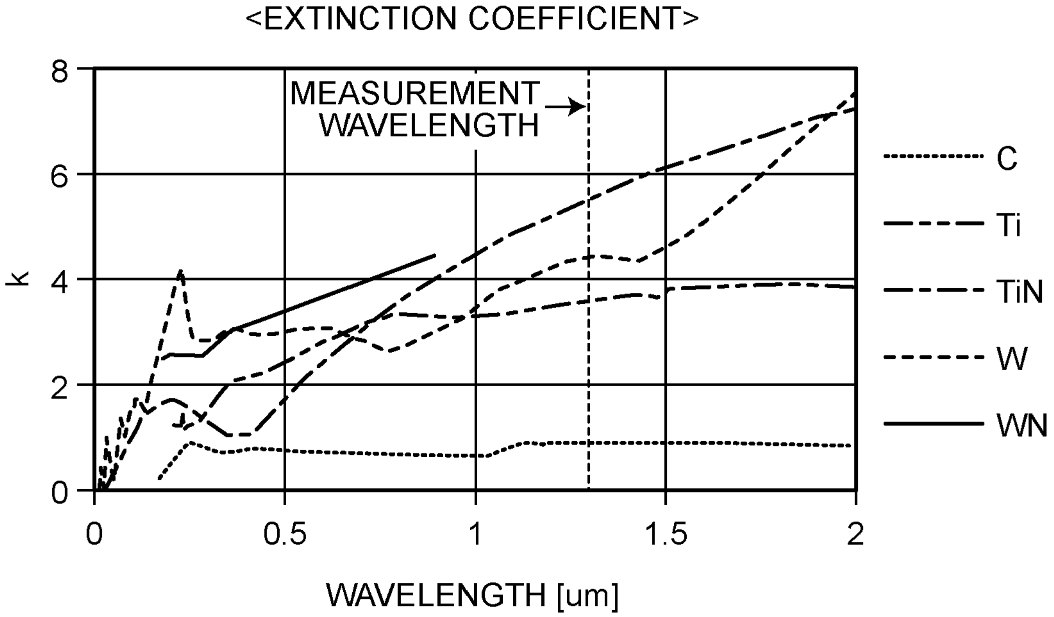

FIG.17

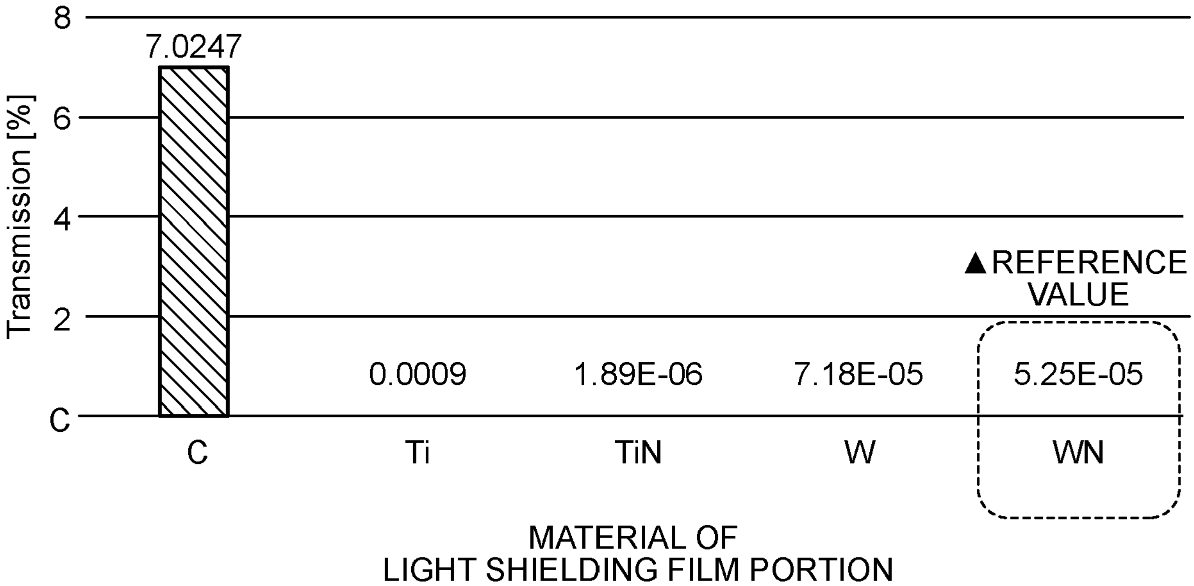
8
7.0247
6
4
2
C
Transmission [%]
▲REFERENCE
VALUE
0.0009
1.89E-06
7.18E-05
5.25E-05
C
Ti
TiN
W
WN
MATERIAL OF
LIGHT SHIELDING FILM PORTION

Europäisches Patentamt
European Patent Office
Office européen des brevets

# EUROPEAN SEARCH REPORT

Application Number
EP 24 16 0062

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2016/099187 A1 (LIAN LEI [US]) 7 April 2016 (2016-04-07) * paragraph [0003] * * paragraph [0029] * * paragraph [0054] - paragraph [0064] * * figure 4 * | 1,2,4-7, 9-13 | INV. H01L21/311 H01L21/67 H01L21/66 |
| Y | US 2020/295068 A1 (SATO NAOYUKI [JP]) 17 September 2020 (2020-09-17) * paragraph [0145] - paragraph [0149] * * figure 3 * | 1,2,4-7, 9-13 | |
| A | US 2020/273705 A1 (SINGH TEJINDER [US] ET AL) 27 August 2020 (2020-08-27) * paragraph [0023] * * paragraph [0038] - paragraph [0040] * * paragraph [0054] - paragraph [0056] * | 1-13 | |
| A | JP 2015 115591 A (TOKYO ELECTRON LTD) 22 June 2015 (2015-06-22) * the whole document * | 1-13 | |

TECHNICAL FIELDS SEARCHED (IPC)

H01L
G01K

The present search report has been drawn up for all claims

1

| Place of search | Date of completion of the search | Examiner |
|---|---|---|
| The Hague | 12 July 2024 | Boubal, François |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 16 0062

This annex lists the patent family members relating to the patent documents cited in the above-mentioned European search report. The members are as contained in the European Patent Office EDP file on
The European Patent Office is in no way liable for these particulars which are merely given for the purpose of information.

12-07-2024

| Patent document cited in search report | Publication date | Patent family member(s) | Publication date |
|---|---|---|---|
| US 2016099187 A1 | 07-04-2016 | US 2015011027 A1 | 08-01-2015 |
| | | US 2016099187 A1 | 07-04-2016 |
| US 2020295068 A1 | 17-09-2020 | CN 111183522 A | 19-05-2020 |
| | | DE 112018004413 T5 | 20-05-2020 |
| | | KR 20200057715 A | 26-05-2020 |
| | | KR 20230168283 A | 13-12-2023 |
| | | US 2020295068 A1 | 17-09-2020 |
| | | US 2022320167 A1 | 06-10-2022 |
| | | WO 2019069556 A1 | 11-04-2019 |
| US 2020273705 A1 | 27-08-2020 | CN 113490997 A | 08-10-2021 |
| | | JP 7314293 B2 | 25-07-2023 |
| | | JP 2022521232 A | 06-04-2022 |
| | | KR 20210121264 A | 07-10-2021 |
| | | TW 202105471 A | 01-02-2021 |
| | | US 2020273705 A1 | 27-08-2020 |
| | | WO 2020176181 A1 | 03-09-2020 |
| | | WO 2020176502 A1 | 03-09-2020 |
| JP 2015115591 A | 22-06-2015 | JP 6231370 B2 | 15-11-2017 |
| | | JP 2015115591 A | 22-06-2015 |
| | | KR 20150070025 A | 24-06-2015 |
| | | TW 201534859 A | 16-09-2015 |
| | | US 2015168130 A1 | 18-06-2015 |
| | | US 2019137260 A1 | 09-05-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2023030028 A